# EUROPEAN PATENT APPLICATION

(11) **EP 0 999 451 A2**
(43) Date of publication of application: **10.05.2000**
(21) Application number: 99308730.3
(22) Date of filing: 03.11.1999
(51) Int. Cl.: G01R 1/073

(54) **Connecting apparatus, method of fabricating wiring film with holder, inspection system and method of fabricating semiconductor element**

(30) Priority: 05.11.1998 JP 31443398
(71) Applicant: NITTO DENKO CORPORATION, Osaka (JP)
(72) Inventor: Kasukabe, Susumu, Yokohama-shi (JP); Mori, Terutaka, Urayasu-shi (JP); Watanabe, Takayoshi, Fujisawa-shi (JP); Ariga, Akihiko, Musashimurayama-shi (JP); Sugimoto, Masakazu, Ibaraki-shi (JP); Inoue, Yasushi, Ibaraki-shi (JP); Ban, Naoto, Sagamihara-shi (JP)
(74) Representative: Paget, Hugh Charles Edward

(57) **Abstract**

A connecting apparatus, a method of fabricating a wiring film with a holder, an inspection system and a method of fabricating a semiconductor element. The connecting apparatus is brought into electrical contact with at least an electrode (3) arranged on an object to be inspected (1) and transmits and receives electrical signals to and from the electrode. A multilayer film (44) includes a support member (40) for supporting the connecting apparatus, a plurality of contact terminals (47) arrayed on the probing side in a working area (44a), a plurality of lead wires (48) electrically connected to each of the contact terminals (47) through a conductive material in an insulating film (71) and led out, a ground layer (49), and a metal film (51) attached to the back of the ground layer (49) by an insulating adhesive (75). A holding member (55) is fixed on the back of the multilayer film (44). A device (42) applies a contact pressure from the support member to the holding member for bringing each contact terminal into contact with each electrode. A compliance mechanism (43c, 41a, 42) sets the surface defined by the contact terminal group in parallel according to the surface defined by the electrode group.

## Description

### BACKGROUND OF THE INVENTION

The present invention relates to a connecting apparatus used for transmitting electrical signals to electrodes in opposed relation thereto through at least a contact terminal in contact with the corresponding electrode and determining the legitimacy of an object to be inspected such as a semiconductor element, a method of fabricating the connecting apparatus and a method of fabricating a wiring film with a holder member, or more in particular to a connecting apparatus for preventing the damage to the object to be inspected such as a semiconductor element, a method of fabricating a wiring film with a holder constituting the connecting apparatus, an inspection system and a method of fabricating the semiconductor element.

As a conventional thin probe card capable of inspecting the electrical characteristics of a semiconductor element such as VLSI at wafer level, a technique (prior art 1) is known which is described in a collection of theses presented as lectures entitled "MEMBRANE PROBE CARD TECHNOLOGY" pp. 601-607, International Test Conference, 1988. In the probe for conductor inspection described in the prior art 1, a wiring is formed by lithography on the upper surface of a flexible dielectric film, through holes of the dielectric film arranged at positions corresponding to the electrodes of semiconductor elements constituting an object to be inspected are plated thereby to form at least a hemispherical bump, and the resulting assembly is used as a contact terminal. The prior art 1 is an inspection method in which the wiring formed on the surface of the dielectric film and the bump connected to the inspection circuit through a wiring board are brought into contact by rubbing the bump with the electrodes of the semiconductor element constituting an object to be inspected by a leaf spring thereby to transmit/receive signals.

The conventional probe devices disclosed in JP-A-8-220138 (prior art 2) and JP-A-7-283280 (prior art 3) are known.

The prior art 2 discloses a technique in which a metal conductor layer is formed on the back of a thin semiconductor pattern formed with a metal protrusion and grounded to assure impedance matching and reduce the inductance as a microstrip line structure.

The prior art 3, on the other hand, discloses a probing device in which a contact terminal with a sharp forward end obtained by anisotropic etching of a crystalline cast is secured by connecting with the lead wire formed on an insulating film, and this insulating film is integrated with a wiring board through a buffer layer and a silicon wafer constituting a substrate.

### SUMMARY OF THE INVENTION

In a probe formed with a flat or a hemispherical bump described in the prior art 1 and the prior art 2, a contact point (protruded electrode) is rubbed (scribed) against a material to be contacted having the surface thereof formed with an oxide such as an aluminum electrode or a solder electrode, so that the oxide is rubbed off from the surface of the electrode material, and the metal conductor material on the lower surface thereof is brought into good contact thereby to secure a superior contact. Scribing the electrode with a contact point causes shavings or scrapings of the electrode material, thereby causing the short-circuiting of the wires and generation of foreign matter. Also, assuring the contact by rubbing the probe against the electrode under a load of not less than several hundred mN often damages the electrode.

In the prior art 3, on the other hand, a thin probe is fabricated by the process of sequentially accumulating a component material. This prior art, therefore, requires a sophisticated process management.

As described above, all the prior art fail to take into consideration sufficiently, with the density of the object to be inspected such as a semiconductor element ever on the increase, the need of realizing a simple fabrication process and structure for realizing a probing for a narrow-pitch multi-pin structure under a small load in stable fashion without damaging the object.

Any of the prior art takes into full consideration neither a structure for preventing the deformation of the probe structure due to the difference in coefficient of thermal expansion between component materials in a test conducted at different ambient temperatures (say, -10°C to 150°C) nor a structure for preventing the displacement of the forward end of the probe due to the difference in coefficient of linear expansion between the probe structure and the object to be inspected at the time of probing.

An object of the present invention is to solve the problem described above and to provide a connecting apparatus and an inspection system for realizing, in stable fashion under a light load and without damaging the object to be inspected, the probing of a narrow-pitch multi-pin structure meeting the trend toward the higher density of the object to be inspected such as a semiconductor element, and capable of transmitting a high-speed electrical signal, i.e. a high-frequency electrical signal.

Another object of the invention is to provide a connecting apparatus and an inspection system for realizing the connection stably with a low resistance without generating shavings or scrapings of the electrical material, etc. simply by pressing, under a light load, the contact terminals against the electrodes on the object to be inspected.

Still another object of the invention is to provide a connecting apparatus and an inspection system having a structure for preventing the displacement of the position of the tip of the probe with the temperature change at the time of inspection when conducting the inspection by bringing the contact terminals into contact with the object to be inspected.

Yet another object of the invention is to provide a method of fabricating, in a short period of time with high yield, a wiring film with a holding member constituting a connecting apparatus for connecting the contact terminals to the electrodes on the object to be inspected with a low resistance in stable fashion.

A further object of the invention is to provide a method of fabricating a semiconductor element by realizing, under a light load and in stable fashion, the probing of a narrow-pitch multi-pin structure meeting the trend toward a higher density of semiconductor elements without damaging the semiconductor elements and realizing the operating test of the semiconductor element with high reliability using a connecting apparatus capable of transmission of high-speed electrical signals, i.e. high-frequency electrical signals.

In order to achieve the objects described above, according to one aspect of the present invention, there is provided a connecting apparatus for transmitting and receiving electrical signals by electrical contact with the electrodes arranged on an object to be inspected, comprising a support member for supporting the connecting apparatus; a multilayer film including a plurality of contact terminals formed on the probing side in a working area, a plurality of lead wires connected to the contact terminals electrically through a conductive material in an insulating film and led to the peripheral area and a metal film formed by being partially lined on the lead wires at positions corresponding to the working area through an insulating layer (adhesive); a holding member (including a frame member) for mounting at least the metal film portion of the multilayer film in such a manner as to eliminate the loosening of the working area of the multilayer film; and contact pressure application means for applying the contact pressure from the support member to the holding member for bringing each contact terminal into contact with a corresponding one of the electrodes.

According to another aspect of the invention, there is provided a connecting apparatus for transmitting and receiving electrical signals by electrical contact with the electrodes arranged on an object to be inspected, comprising a support member for supporting the connecting apparatus comprising a support member for supporting the connecting apparatus; a multilayer film including a plurality of contact terminals formed on the probing side in a working area, a plurality of lead wires connected to the contact terminals electrically through a conductive material in an insulating film and led to the peripheral area, a ground layer formed in opposed relation to the lead wires with an insulating layer therebetween, and a metal film formed by being partially lined on the ground layer at positions corresponding to the working area through an insulating layer (adhesive); a holding member (including a frame member) for mounting at least the metal film portion of the multilayer film in such a manner as to eliminate the loosening of the working area of the multilayer film; and contact pressure application means for applying the contact pressure from the support member to the holding member for bringing each contact terminal into contact with a corresponding one of the electrodes.

According to still another aspect of the invention, there is provided a connecting apparatus comprising a compliance mechanism by which the holding member engages the support member in such a manner that the surface defined by the contact terminals is set or arranged in parallel according to the surface defined by the electrode group when the surface of the contact terminal group is brought into contact with the surface of the electrode surface group.

According to yet another aspect of the invention, there is provided a connecting apparatus comprising a buffer layer between the back of the working area of the multilayer film and the holding member.

According to a further aspect of the invention, there is provided a connecting apparatus in which the conductive material for the multilayer film is formed of vias including the insulating film filled with the conducting material.

According to a still further aspect of the invention, there is provided a connecting apparatus in which the conductive material for the multilayer film is formed of solder vias including the insulating film filled with the solder.

According to a yet further aspect of the invention, there is provided a connecting apparatus in which the conductive material in the insulating film for the multilayer film is formed of solder vias embedded in a polyimide film.

According to still another aspect of the invention, there is provided a connecting apparatus in which the metal film is a metal material having a coefficient of linear expansion of 1 to 5 ppm/°C.

According to yet another aspect of the invention, there is provided a method of fabricating a wiring film with a holding member constituting a connecting apparatus for transmitting and receiving electrical signals by electrical contact with the electrodes arranged on an object to be inspected, comprising the steps of:
forming an etching hole with a sharp or pointed tip at a plurality of points on a cast, and forming a plurality of contact terminal electrodes of a conductive material each having a protrusion for the contact terminal in an area including the etching holes, thereby producing a plurality of contact terminals with a cast;
forming at least a lead wire on an insulating film, forming a plurality of via holes in an adhesive layer connected to an end of the lead wires, attaching the adhesive layer on the lead wires, forming a plurality of via holes each connected to an end of each of the lead wires on the insulating layer, and filling a conductive material in the via holes, thereby producing a wiring film;
laying each contact terminal with a cast obtained in the contact terminal forming step and the wiring film obtained in the wiring film forming step, one on the other, heating the assembly under pressure thereby to embed the base of the contact terminal electrode in the adhesive layer and connect the contact terminals with the vias, and bonding the contact terminals with a cast and the wiring film with the adhesive layer, thereby producing a wiring film with a cast;
mounting a holding member on that surface of the wiring film with a cast obtained in the mounting step which is the opposite side of the contact terminals; and
removing the cast from the wiring film obtained in the mounting step, connecting the wiring film with the vias, and embedding the base of the wiring film in the adhesive layer, thereby producing a wiring film having a protruded contact terminal.

According to a further aspect of the invention, there is provided a method of fabricating a wiring film with a holding member constituting a connecting apparatus for transmitting and receiving electrical signals by electrical contact with the electrodes arranged on an object to be inspected, comprising the steps of:
forming an etching hole with a sharp or pointed tip at a plurality of points on a cast, and forming at least a contact terminal electrode of a conductive material having a protrusion for the contact terminal in an area including the etching holes, thereby producing a plurality of contact terminals with a cast;
forming at least a lead wire on an insulating film, attaching an adhesive layer on the lead wire, forming a plurality of via holes in the adhesive layer connected to an end of the lead wires, and filling a conductive material in the via holes, thereby producing a wiring film;
laying each contact terminal with a cast obtained in the contact terminal forming step and the wiring film obtained in the wiring film forming step, one on the other, heating the assembly under pressure thereby to embed the base of the contact terminal electrode in the adhesive layer and connect the contact terminal with the vias, and bonding the contact terminal with a cast and the wiring film with the adhesive layer, thereby producing a wiring film with a cast;
mounting a holding member on that surface of the wiring film with a cast obtained in the mounting step which is the opposite side of the contact terminal; and
removing the cast from the wiring film obtained in the mounting step, connecting the wiring film with the vias, and embedding the base of the wiring film in the adhesive layer, thereby producing a wiring film having a protruded contact terminal.

According to a still further aspect of the invention, there is provided a method of fabricating a wiring film with a holding member constituting a connecting apparatus for transmitting and receiving electrical signals by electrical contact with the electrodes arranged on an object to be inspected, comprising the steps of:
forming an etching hole with a sharp tip at a plurality of points on a cast, and forming a contact terminal electrode of a conductive material having a protrusion for the contact terminal in an area including the etching holes, thereby producing a plurality of contact terminals with a cast;
forming a lead wire on an insulating film, forming a plurality of via holes on the lead wire at positions connected to an end of the lead wire, attaching an adhesive sheet filled with a conductive material on the via holes, thereby producing a wiring film;
laying each contact terminal with a cast obtained in the contact terminal forming step and the wiring film obtained in the wiring film forming step, one on the other, heating the assembly under pressure thereby to embed the base of the contact terminal electrode in the adhesive sheet and connect the contact terminal with the vias, and bonding the contact terminal with a cast and the wiring film to each other with the adhesive sheet, thereby producing a wiring film with a cast;
mounting a holding member on that surface of the wiring film with a cast obtained in the mounting step which is the opposite side of the contact terminals; and
removing the cast from the wiring film with a cast obtained in the mounting step, connecting the wiring film with the vias, and embedding the base of the wiring film in the adhesive sheet, thereby producing a wiring film having a protruded contact terminal.

According to a yet further aspect of the invention, there is provided a method of fabricating a wiring film with a holding member, wherein the step of forming a wiring film further includes the substep of bonding a metal film by lining on the back or above the back of the insulating film of the wiring film using an adhesive.

According to another aspect of the invention, there is provided a method of fabricating a wiring film with a holding member, wherein the step of forming a wiring film further includes the substep of bonding a metal film having a coefficient of linear expansion of 1 to 5 ppm/°C by lining on the back or above the back of the insulating film of the wiring film using an adhesive.

According to still another aspect of the invention, there is provided a method of fabricating a wiring film with a holding member, wherein the adhesive layer used in the step of forming a wiring film is made of polyimide.

According to yet another aspect of the invention, there is provided a method of fabricating a wiring film with a holding member, wherein the adhesive sheet used in the step of forming a wiring film is made of polyimide.

According to a further aspect of the invention, there is provided a method of fabricating a wiring film with a holding member, wherein the vias formed in the step of forming a wiring film are solder vias.

According to a still further aspect of the invention, there is provided a method of fabricating a wiring film with a holding member, wherein the step of forming the wiring film further includes the substep of forming a ground layer on the back of the insulating layer of the wiring film.

According to a yet further aspect of the invention, there is provided a method of fabricating a wiring film with a holding member, wherein the step of forming the wiring film further includes the substeps of forming a ground layer on the back of the insulating layer of the wiring film and bonding a metal film, using an adhesive, on the back of the ground layer formed in the ground layer forming step.

According to another aspect of the invention, there is provided a method of fabricating a wiring film with a holding member, wherein the step of forming the wiring film further includes the substeps of forming a ground layer on the back of the insulating layer of the wiring film and bonding a metal film having a coefficient of linear expansion of 1 to 5 ppm/°C, using an adhesive, on the back of the ground layer formed in the ground layer forming step.

According to still another aspect of the invention, there is provided a method of fabricating a wiring film with a holding member, wherein the mounting step includes the substep of removing the desired portion exposed by the metal film in such a manner that the wiring film with a holder can be bent when mounting the holding member.

According to yet another aspect of the invention, there is provided an inspection system comprising:
a sample support system for mounting and supporting an object to be inspected thereon,
a connecting apparatus including a support member; a multilayer film including a plurality of contact terminals formed on the probing side of a working area, a plurality of lead wires electrically connected to each of the contact terminals through a conductive material in an insulating film and led out to the peripheral portion of the multilayer film, a ground layer formed in opposed relation to the lead wires with an insulating layer therebetween, and a metal film formed by being partially lined at positions corresponding to the working area on the ground layer with the insulating layer therebetween; a holding member for mounting at least the metal layer portion of the multilayer film in such a manner as to eliminate the loosening of the working area of the multilayer film; and means for applying a contact pressure from the support member to the holding member for bringing each of the contact terminals into contact with each of the electrodes,
a tester electrically connected to the lead wire led out to the peripheral portion of the multilayer film of the connecting apparatus,
means for positioning the group of the contact terminals formed on the multilayer film of the connecting apparatus and the group of the electrodes arranged on the object to be inspected, and
means for bringing the contact terminal group positioned by the positioning means and the electrode group arranged on the object to be inspected into contact with each other, so that an electrical signal is transmitted and received between the object to be inspected and the tester thereby to inspect the object to be inspected.

According to a further aspect of the invention, there is provided a method of fabricating at least a semiconductor element by bringing the contact terminal group into contact with the electrode group arranged in each semiconductor element, transmitting and receiving electrical signals to and from the semiconductor element from a tester and thus inspecting the electrical characteristics of the semiconductor element, using an inspection system comprising:
a sample support system for mounting and supporting a semiconductor element thereon,
a connecting apparatus including a support member; a multilayer film including a plurality of contact terminals formed on the probing side of a working area, a plurality of lead wires electrically connected to each of the contact terminals through a conductive material in an insulating film and led out to the peripheral portion of the multilayer film, a ground layer formed in opposed relation to the lead wires with an insulating layer therebetween, and a metal film formed by being partially lined at positions corresponding to the working area on the ground layer with the insulating layer therebetween; a holding member for mounting at least the metal layer portion of the multilayer film in such a manner as to eliminate the loosening of the working area of the multilayer film; and means for applying a contact pressure from the support member to the holding member for bringing the forward end of each of the contact terminals into contact with each of the electrodes,
a tester electrically connected to the lead wire led out to the peripheral portion of the multilayer film of the connecting apparatus, and
means for positioning the group of the contact terminals formed on the multilayer film of the connecting apparatus and the group of the electrodes arranged on the semiconductor element.

As described above, with the configuration described above, the probing of a narrow-pitch multi-pin structure having a high density of semiconductor elements is realized with a small load in stable fashion without damaging the object to be inspected, and in addition, the transmission of a high-speed electrical signal, i.e. a high-frequency electrical signal (radio frequencies of about 100 MHz to several tens of GHz) is made possible.

With the configuration described above, the apparatus comprises a compliance mechanism for eliminating the loosening of the working area of a multilayer film where a plurality of contact terminals are formed on the one hand and setting the contact terminals in parallel on the other hand, whereby by simply pressing the contact terminals against the electrode group on the object to be inspected under a small load of about 3 to 50 mN per pin, a stable connection is realized with a resistance as low as about 0.05 Ω to 0.1 Ω without generating any shavings or scrapings of the electrode material, etc.

With the configuration described above, one or a multiplicity of semiconductor elements (chips) among those formed in the state of wafer can be accurately and simultaneously connected to the electrodes of aluminum or solder having an oxide formed on the surface thereof with a small contact pressure (about 3 to 50 mN per pin) and a stable resistance as low as about 0.05 Ω to 0.1 Ω. In this way, the operation test can be conducted on each semiconductor element by tester. Specifically, this configuration can meet the requirement of high density and small pitch of the electrodes and permits the simultaneous inspection by probing of a multiplicity of chips, so that an operation test is made possible with a high-speed electrical signal (high frequency of about 100 MHz to several tens of GHz).

With the configuration described above, a metal film pattern having about the same coefficient of linear expansion as the object to be inspected and fixed by being partially lined on the back of a wiring film with contact terminals at positions corresponding to the working area with the contact terminals formed. Even when the temperature changes at the time of inspection (-10 °C to 150°C), therefore, the position of the contact terminals formed on the wiring film is stabilized relative to the position of the electrodes of the object to be inspected (semiconductor elements, for example), thereby realizing a connecting apparatus high in position accuracy.

With the configuration described above, a metal film pattern is fixedly by being partially lined on the back of a wiring film with contact terminals at positions corresponding to the working area with the contact terminals formed, so that the wiring film is reinforced thereby to realize a reliable connecting apparatus.

With the configuration described above, contact terminals with a cast and a wiring film are laid one on the other and heated under pressure, so that the base of the contact terminal electrodes is embedded in an adhesive to connect with vias, so that the contact terminals with the cast are bonded with the wiring film by the adhesive, and the cast is then removed to fabricate a wiring film. In this way, a wiring film with a holding member constituting the connecting apparatus can be fabricated inexpensively with high yield within a short length of time.

With the configuration described above, a metal film having about the same coefficient of linear expansion as the cast is fixedly with an adhesive on the back of a wiring film, so that the crack, separation, etc. of the lead wires and the polyimide film which otherwise might be caused by the difference in the coefficient of linear expansion due to the temperature stress during the fabrication process are prevented thereby to improve the yield of the wiring film. At the same time, by etching off the exposed metal film in the final stage of the fabrication process as required, a flexible wiring film can be provided as the final product while at the same time securing the connection by the contact terminals to the object to be inspected.

### BRIEF DESCRIPTION OF THE DRAWINGS

Fig. 1(a) is a perspective view showing a wafer providing an object to be inspected having a plurality of semiconductor elements (chips) arranged therein.

Fig. 1(b) is a perspective view of a semiconductor element (chip).

Fig. 2 is a sectional view of the parts of a connecting apparatus according to a first embodiment of the invention.

Fig. 3 is a sectional view of the parts of a connecting apparatus according to a second embodiment of the invention.

Fig. 4 is a sectional view of the parts of a connecting apparatus according to a third embodiment of the invention.

Fig. 5 is a partial sectional view showing the lead wire and the ground layer arranged in opposed relation to each other with an insulating film interposed therebetween in a multilayer wiring film according to the invention.

Fig. 6A is a plan view showing a polyimide film formed with contact terminals and lead wires for a connecting apparatus according to an embodiment of the invention.

Fig. 6B is a perspective view of the same polyimide film.

Fig. 7 is a sectional view showing the dimensions and cast of the contact terminals and the multilayer film with the contact terminals juxtaposed thereon for a connecting apparatus according to the invention.

Figs. 8A to 8E are sectional views showing the fabrication process for forming the tip of the probe with a silicon wafer cast for a connecting apparatus according to the first to third embodiments of the invention.

Figs. 9A to 9E are sectional views showing the fabrication process of forming a metal film on the lead wire film formed with vias of a conductive material for a connecting apparatus according to the first to third embodiments of the invention.

Figs. 10A to 10F are sectional views showing the process of fabricating a multilayer wiring film including the holder member and the frame of a connecting apparatus according to the first embodiment of the invention.

Figs. 11A to 11D are sectional views showing the process of fabricating a multilayer wiring film including the holding member of a connecting apparatus according to the second embodiment of the invention.

Figs. 12A to 12D are sectional views showing the process of fabricating a multilayer wiring film including the holding member of a connecting apparatus according to the third embodiment of the invention.

Fig. 13 is a sectional view of the parts of a connecting apparatus according to a fourth embodiment of the invention.

Fig. 14 is a diagram showing a general configuration of an inspection system according to an embodiment of the invention.

### DESCRIPTION OF THE EMBODIMENTS

A connecting apparatus and an inspection apparatus for a semiconductor element fabrication method according to embodiments of this invention will be described with reference to the drawings.

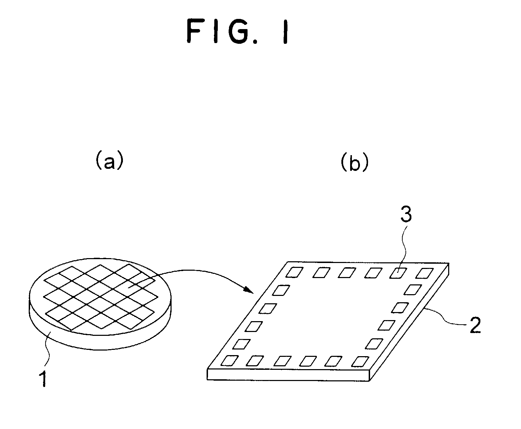

A multiplicity of semiconductor elements (chips) 2 for LSI which is an object to be inspected are formed in a wafer 1 and subsequently cut off for practical service. Fig. 1(a) is a perspective view showing a wafer 1 having a multiplicity of semiconductor elements (chips) 2 for LSI arranged, and Fig. 1(b) is a perspective view showing in enlarged form one semiconductor element (chip) 2. A multiplicity of electrodes 3 are arranged along the periphery on the surface of the semiconductor element (chip) 2.

With the progress of integration degree, the electrodes 3 of the semiconductor element are becoming higher in density and smaller in pitch. As an example of the reduced pitch of the electrodes, the figure is now not more than the order of 0.2 mm. For example, it is 0.13 mm, 0.1 mm or less. As for the increased density of the electrodes, on the other hand, the arrangement of the electrodes along the periphery is now changing from one line to two lines, and there is even a trend toward the arrangement of the electrodes over the whole surface.

Also, a high-temperature operation test (85°C to 150°C) is often conducted for accurately determining the characteristics and reliability of the semiconductor elements.

A connecting apparatus (probing apparatus) according to this invention is used for conducting an operation test on each semiconductor element using a tester by accurately and simultaneously connecting one or a multiplicity of semiconductor elements (chips) formed in a wafer to the electrodes 3 of aluminum or solder with an oxide formed on the surface thereof, with a stable resistance as low as about 0.05 Ω to 0.1 Ω and under a small contact pressure (about 3 to 50 mN per pin). Specifically, the connecting apparatus (probing apparatus) according to this invention can meet the requirement of the trend toward higher density and smaller pitch of the electrodes, permits the inspection by simultaneous probing of a multiplicity of chips, and thus makes possible an operation test with a high-speed electrical signal (high frequency of about 100 MHz to several tens of GHz).

Also, by use of a component material having a heat resistance of about 150°C and about the same coefficient of linear expansion as the object to be inspected, the displacement of the tip of the probe which otherwise might be caused by the ambient temperature can be prevented.

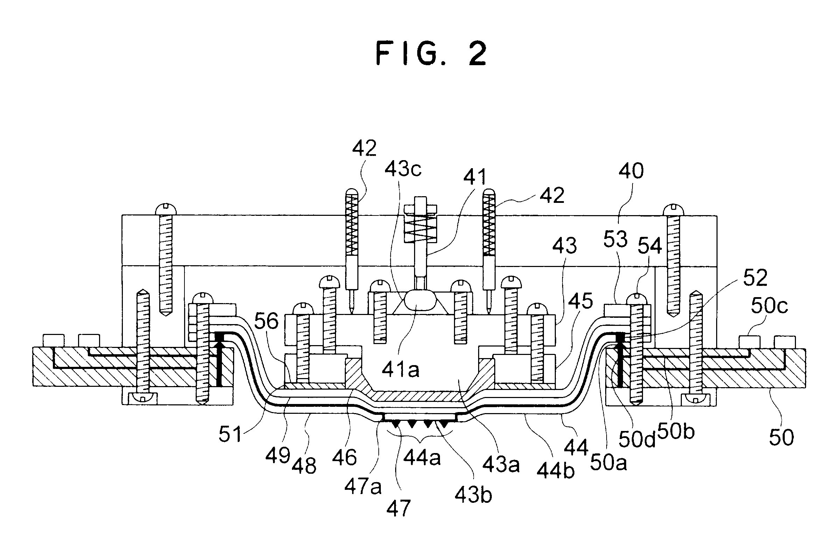

Fig. 2 is a diagram showing the parts of a connecting apparatus according to a first embodiment of the invention. This connecting apparatus according to the first embodiment comprises a support member (upper fixing plate) 40, a center pivot 41 providing a support shaft fixed on the support member 40 and having a spherical surface 41a in the lower portion thereof, spring probes 42 arranged symmetrically laterally and longitudinally about the center pivot 41 as a means for applying an always fixed pressure in response to the vertical displacement, a holding member (holding plate) 43 held inclinably by a taper 43c with respect to the center pivot 41 and supplied with a pressure (pressed) by the spring probes 42, a multilayer wiring film 44, a frame (frame-castd holding member) 45 fixed on the multilayer wiring film 44, a buffer layer 46 arranged between the multilayer wiring film 44 and the holding member 43, lead wires 48 arranged on the multilayer wiring film 44, contact terminals 47 connected to the lead wires 48 through vias 47a filled with a conductive material, a ground layer 49 arranged on the multilayer wiring film 44 and a metal film 51 arranged on the ground layer 49. The pressure applied to the holding member 43 is derived from the spring probes 42 in order to assure a substantially constant light-load pressure against the displacement of the tips of the spring probes, and the spring probes 42 are not necessarily the source of pressure. The engagement between the spherical surface 41a in the lower portion of the center pivot 41 and the taper 43c formed in the upper portion of the holding member 43 and the spring probes 42 constitute a light-load compliance mechanism by which the tips of the contact terminals 47 formed in the work area 44a on the multilayer wiring film 44 are set in parallel, with a light load, following the surface of the electrodes 3 of one or a plurality of semiconductor elements.

The support member (upper fixing plate) 40 is mounted on the wiring board 50. The multilayer wiring film 44 is formed in such a manner that the peripheral edge portion thereof extends outside of the frame (frame-castd holding member) 45. This extension is bent smoothly outside and fixed on the wiring board 50. In the process, the lead wires 48 are electrically connected to electrodes 50a arranged on the wiring board 50. For connecting the lead wires 48 to the electrodes 50a of the wiring board 50, vias 52 filled with a conductive material are formed in the multilayer wiring film 44 and the vias 52 and the electrodes 50a are brought into direct contact with each other under pressure, an anisotropic conductive sheet or solder or the like is used, a connecting pin is inserted in the wiring board 50, or a connecting spring probe is inserted into the wiring board 50.

The wiring board 50 is made of a resin material such as polyimide or glass epoxy resin, and has internal wires 50b and connecting terminals 50c. The electrodes 50a are configured of a via 50d connected to a part of the internal wires 50b, for example. The wiring board 50 and the multilayer wiring film 44 are fixed in such a manner that the multilayer wiring film 44 is held between the peripheral electrode holding member 53 and the wiring board 50 and fixed by use of screws 54 or the like.

The multilayer wiring film 44 is flexible, and preferably formed primarily of a heat-resistant resin. According to this embodiment, the polyimide resin is used. The buffer layer 46 is configured of an elastic material such as elastomer (high-polymer material having a rubber-like elasticity). Specifically, silicon rubber or the like is used. Also, the buffer layer 46 may alternatively be configured by sealing the holding member 43 movably with respect to the frame 45 and supplying a gas into the space formed by this sealing.

Also, as far as the flatness at the height of the tip of the contact terminal 47 can be secured, the buffer layer 46 may be done without.

The contact terminal 47, the lead wires 48 and the ground layer 49 are made of a conductive material. This configuration will be described in detail later. In Fig. 2, the contact terminals 47 and the lead wires 38 only for two chips are shown for simplicity. Actually, however, a plurality of contact terminals 47 and lead wires 48 are arranged as described later.

First, a connecting apparatus (probing apparatus) according to this invention is intended to assure that one or a multiplicity of semiconductor elements (chips) formed in wafer form are connected simultaneously to the electrodes 3 of aluminum or solder formed with an oxide on the surface thereof, under a light load (about 3 to 50 mN per pin) and a stable resistance as low as about 0.05 Ω to 0.1 Ω. This eliminates the need of the conventional scribe operation and can prevent generation of shavings or scrapings of the electrode material which otherwise might be generated. Specifically, the tips of the contact terminals 47 of the multilayer wiring film 44 which are arranged in adjoining relation at positions corresponding to the electrodes 3 are sharpened. At the same time, the working area 44a supported by the frame 45 with the contact terminals 47 disposed within the peripheral portion 44b is extended relative to the peripheral portion 44b, with the buffer layer 46 in-between, along the lower surface 43b having a high-accuracy flatness of the protrusion 43a formed under the holding member 43 thereby to eliminate the loosening of the multilayer wiring film. The sharpened tips of the contact terminals 47 disposed in the extended working area 44a are set in parallel according to the surface of the arrangement of the electrodes (contacted members) 3 of aluminum or solder by the light-load compliance (tracking) mechanism. By thus probing at right angles to the electrode surface with a light load (about 3 to 50 mN per pin), the tips of the contact terminals 47 can easily break through the oxide formed on the surface of the electrodes (contacted members) 3 and can be easily brought into good contact with the metal conductive material of the electrodes under the lower surface of the oxide in stable fashion with as low a resistance value as about 0.05 Ω to 0.1 Ω.

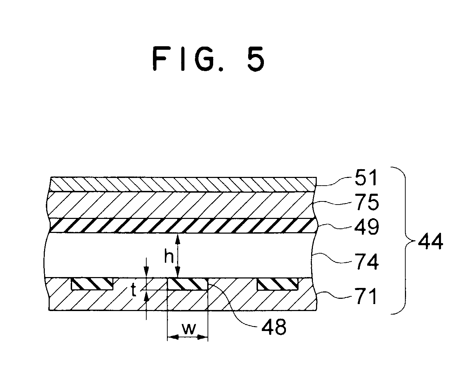

Also, the multilayer wiring film 44, as shown in Fig. 5, includes a ground layer 49 arranged, with a polyimide film 74 therebetween, in opposed relation to the lead wire 48 connected to each contact terminal 47. The dielectric constant εr and thickness (gap between the lead wire 48 and the ground layer 49) h of the polyimide film 74 and the width w and thickness t of the lead wire 48 are set to an appropriate value, with the impedance Zo of the lead wire 48 being set to about 50 ohm, thereby securing the matching with the tester circuit. As a result, the disturbance and attenuation of the electrical signal transmitted through the lead wire 48 are prevented, and the inspection of the electrical characteristics of a semiconductor element by a tester can be realized with a high-speed electrical signal which can meet up to the high frequency as high as about 100 MHz to several tens of GHz.

As described above, the multilayer wiring film 44 includes the ground layer 49 arranged in opposed relation, with the polyimide film 74 therebetween, to the lead wire 48 connected to each contact terminal, so that the impedance can be set to about 50 ohm capable of securing the matching with the tester circuit, while setting the other probes (contact terminals) are set to the length equivalent only to the contact terminal portion (about 0.05 to 0.5 mm) 47. The matching with the tester circuit can thus be secured. In this way, the inspection of the electric characteristics of a semiconductor element with a high-speed electrical signal is realized with a suppressed disturbance of the high-speed electrical signal.

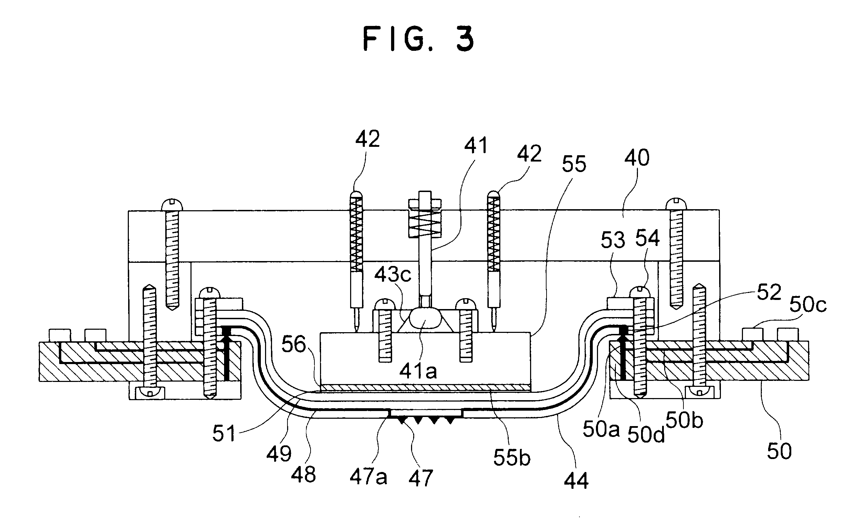

Fig. 3 is a diagram showing the parts of a connecting apparatus according to the second embodiment of the invention. In the connecting apparatus according to the second embodiment, the multilayer wiring film 44 is fixed by an adhesive 56 to the lower surface 55b of the holding member 55. Specifically, according to the second embodiment, the multilayer wiring film 44 is fixed to the lower surface 55b of the holding member 55 by the adhesive 56 to prevent the loosening of at least the working area with the contact terminals 47 disposed therein and thereby to secure the flatness of the tip height of the contact terminals 47. An epoxy group adhesive or a polyimide adhesive can be used as the adhesive 56. The remaining configuration is identical to the corresponding one of the first embodiment shown in Fig. 2. Specifically, the engagement between the spherical surface 41a in the lower portion of the center pivot 41 and the taper 43c in the upper portion of the holding member 55 and the spring probe 42 make up a light-load compliance mechanism in which the contact terminals 47 or the tips thereof arranyed in the working area 44a of the multilayer wiring film 44 are set in parallel according to the contour of the surface of the electrodes 3 arranged on the object to be inspected (wafer) with a light load.

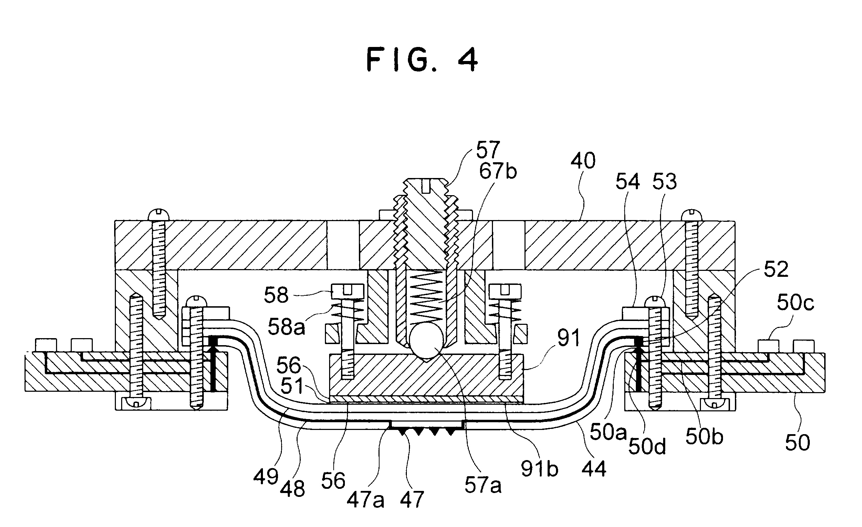

Fig. 4 is a diagram showing the parts of a connecting apparatus according to a third embodiment of the invention. In the connecting apparatus according to the third embodiment, a center pivot 57 having a spherical forward end portion 57a is used in place of the center pivot 41 having the configuration shown in Fig. 2, so that the pressure against the holding member 91 is applied by the spring 57b, and through the spring 58a of the spring 58 fixed on the periphery of the holding member 91, the holding member 91 is kept rotatable while being kept in contact with the spherical tip portion 57a. Also in this third embodiment, the engagement between the spherical tip portion 57a supplied with the pressure by the spring 57b of the center pivot 57 and the conical groove formed in the upper surface of the holding member 91 and the spring 58a make up a light-load compliance mechanism in which the contact terminals 47 or the tips thereof arrayed in the working area 44a of the multilayer wiring film 44 are set in parallel according to the contour of the electrodes arranged on the object to be inspected (wafer) with a light load. The springs 57b, 58a are formed to apply a light load. Also, in order not to loosen at least the working area with the contact terminals 47 arranged therein, the multilayer wiring film 44 is required to be fixed on the lower surface 91b of the holding member 91 by the adhesive 56 and thereby to secure the flatness of the height of the contact terminals 47. The other configuration is the same as that of the second embodiment shown in Fig. 3.

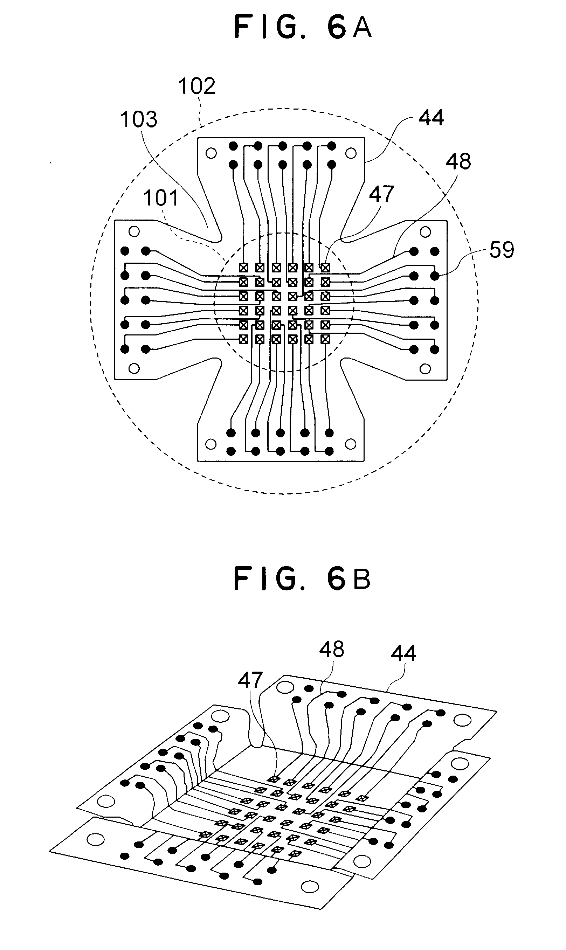

The arrangement of the contact terminals and the wiring pattern of the lead wire of the connecting apparatuses described above can be variously configured in accordance with the electrode pattern of the object to be inspected or a semiconductor integrated circuit, for example. An embodiment of the configuration will be explained with reference to Figs. 6A, 6B.

Fig. 6A is a plan view showing the arrangement of the contact terminals and the lead wires of a connecting apparatus according to an embodiment of the invention. Fig. 6B is a perspective view showing the bent state of the multilayer wiring film having the wires. In Figs. 6A, 6B, a fewer number of contact terminals and lead wires with a lower density than in the actual case are shown for simplicity and facilitating the understanding. Actually, a multiplicity of contact terminals are of course provided with higher density.

Now, a method of fabricating these connecting apparatuses will be briefly explained.

As a method of leading the wire of the connecting apparatus to transmit electrical signals to the inspection system, consider the case in which the object to be inspected is the electrodes on the surface of the LSI formed on a wafer. First, as shown in Fig. 6A, using a contact terminal forming cast 102 of a silicon wafer or the like larger than the area 101 formed with the LSI, holes for forming the contact terminals 47 are formed in the same area 101 as the LSI forming wafer by anisotropic etching of a silicon wafer with silicon dioxide as a mask, thereby producing a cast. Using this cast, protrusions are formed for constructing the contact terminals 47. Further, a polyimide film and the lead wires 48 are formed on the surface of the contact terminal forming cast 102 thereby to form the multilayer wiring film 44. Also, as required, the multilayer wiring film 44 is cut with a perforation 103 as shown in Fig. 6A. The area of the multilayer wiring film 44 corresponding to the inspection area 101 of the LSI forming wafer having the contact terminals 47 formed therein is bent, as shown in Fig. 6B, in such a manner as to be surrounded by a polygon, by fixing the frame 45 or the holding members 55, 91 on the back of the multilayer wiring film 44. Further, in the case of Fig. 2, a buffer layer 46 is held between the multilayer wiring film 44 with a frame and the holding member 43 and mounted integrally, and after removing the contact terminal forming cast 102, the assembly is placed on the upper fixing board 40 and the wiring board 50. The electrodes 59 of the lead wires 48 are brought into contact with the electrodes 50a of the wiring board 50 by applying direct pressure thereto, or they are connected using an anisotropic conductive sheet or solder, or connected by inserting at least a connecting pin into the wiring board 50, or connected by inserting at least a connecting spring probe into the wiring board 50, with the peripheral electrode holding member 53 connected by screws 54 to the wiring board 50.

The embodiment described above represents the case in which the electrodes of all the semiconductor elements formed in a wafer constituting an object to be inspected are brought into contact at the same time. The invention is, however, not limited to such a case. For example, a connecting apparatus can be fabricated with the multilayer wiring film having an area smaller than the wafer for inspecting the semiconductor elements individually or an arbitrary number of the semiconductor elements at the same time.

Now, an explanation will be given of a structure and a method of fabricating the contact terminal portion of a connecting apparatus according to the first embodiment of the invention.

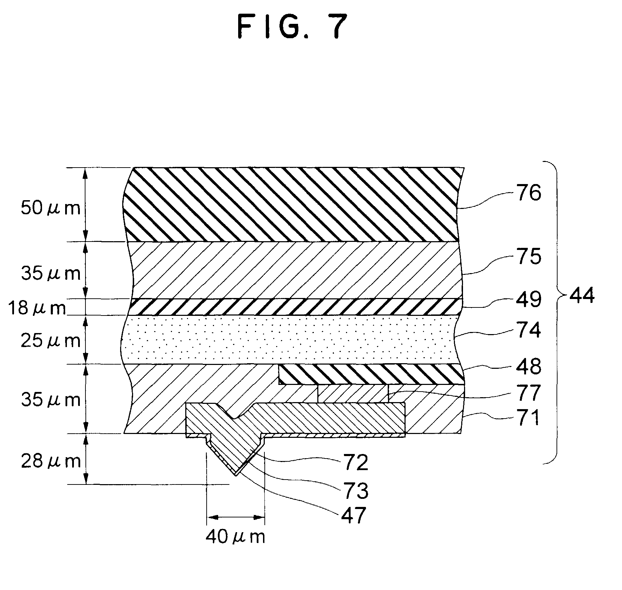

The contact terminal portion shown in Fig. 7 is constituted of the multilayer wiring film 44 having a polyimide film 71 as the lowest layer, a bump 77 for forming a protrusion and a plated film 73 to be deposited at the tip portion thereof. Also, the surface (the surface opposed to the board) of the polyimide film 71 is formed with a lead wire 48, a polyimide film 74, a ground layer 49, a polyimide film 75 and a metal film (finally patterned in such a manner that the multilayer wiring film can be bent) 76. The lead wire 48 has an end thereof electrically connected to the bump 72 through the solder via 77. The contact terminal 47 is formed, for example, of the bump 72 having a sharp pyramidal tip and the plated film 73 formed on the surface of the tip of the bump 72. The bump 72 is composed of nickel or the like material which has a high hardness and easy to plate. The plated film 73 is harder than the nickel film and configured of rhodium or the like.

Fig. 7 shows typical sizes of the contact terminal portion of a connecting apparatus according to the first embodiment of the invention. Specifically, in order to meet the narrow pitch of not more than 0.2 mm, say, 0.13 mm or 0.1 mm, of the electrodes of the semiconductor element, the thickness of the ground layer 49 is set to about 18 µm, the thickness of the polyimide layer 74 to about 25 µm, the thickness of the polyimide layer 71 to about 35 µm, the height of the tip of the contact terminal 47 to about 28 µm, and the width of the bottom of the forward end is set to about 40 µm, for example. The upper surface of the ground layer 49 is formed with an adhesive 75 of epoxy group or polyimide group in the thickness of about 35 µm in order to fixedly attach a metal film 76 having a thickness of about 50 µm thereto. According to the first embodiment, a contact terminal 47 is configured in a pyramidal cast having a sharp tip and with one side of the bottom 10 to 60 µm in size. This pyramid is patterned by photolithography using a cast, and therefore the position and size thereof can be determined with high accuracy. Also, it is formed by anisotropic etching with a very sharp cast. Especially, the forward end can have a sharp tip. These features are also shared by other embodiments.

According to this embodiment, the pitch of the electrodes of the semiconductor element is smaller than 0.1 mm, and the contact terminals 47 corresponding to the pitch of about 10 to 20 µm can be easily formed. Specifically, the contact terminal 47 having one side of the bottom thereof as large as about 5 µm can be easily formed. Also, the contact terminal 47 of the multilayer wiring film 44 can be formed to the accuracy of not more than ±2 µm in height. As a result, assume, as shown in Fig. 2 of the first embodiment, that the working area 44a with a multiplicity of these contact terminals 47 arranged therein is extended with the buffer layer 46 therebetween using the holding member (holding plate) 43 thereby to eliminate the loose condition of the multilayer film. Further, as shown in Figs. 3 and 4 as the second and third embodiments, respectively, assume that the working area with a multiplicity of the contact terminals 47 arrayed therein is fixed by the adhesive 56 to the holding members (holding plates) 55 and 91 to eliminate the loose condition of the multilayer wiring film. In both cases, the height accuracy within about ± 2 µm of the contact terminal 47 can be secured, thereby making possible the probing with the electrodes 3 arranged on the semiconductor element in stable fashion under a light load (about 3 to 50 mN per pin).

In the second embodiment shown in Fig. 3, a metal film 51 of invar (an alloy of about 36% nickel and 64% iron, having a coefficient of linear expansion of about 1.5 ppm/°C) having a small difference in the coefficient of linear expansion with respect to the silicon wafer (having a coefficient of linear expansion of about 2.56 to 2.80 ppm/°C (50°C to 100°C)) providing an object to be inspected is fixedly attached to the holding member 55 and the multilayer film holding member 53 by use of the polyimide or epoxy adhesive 75 on the surface of the multilayer film 44 nearer to the holding member (the upper surface of the ground layer 49). For this reason, the metal film 51 corresponding to the holding member 55 covers a wide area including the back of the working area with the contact terminals 47 arrayed therein. Even in the case where the temperature changes by as much as -10°C to 150°C at the time of inspection, therefore, the positions of the contact terminals 47 formed on the multilayer film 44 are more stabilized with respect to the electrodes arranged on the object to be inspected, and the lead wire 48 connecting the contact terminals 47 is reinforced. Thus the probing high in position accuracy and reliable is made possible, and in addition, the reliability of the connection between the metal film 51 corresponding to the peripheral electrode holding member 53 and the wiring board 50 can be improved. Also, the holding member 55 is preferably made of invar or the like material similar to the metal film 51 in order to lessen the difference of the coefficient of linear expansion with the metal film 51 as far as possible.

Also in the third embodiment shown in Fig. 4, the metal film 51 corresponding to the holding member 91 and the metal film 51 corresponding to the holding member 53 for the peripheral electrodes have the same effect as those of the second embodiment shown in Fig. 3. Further, the holding member 91 is preferably made of the same material including invar as the metal film 51 to lessen the difference in the coefficient of linear expansion with the metal film 51 as far as possible.

The tip of the contact terminal 47 is sharpened for the following reason.

Specifically, in the case where the electrodes 3 constituting the object to be inspected are made of aluminum or the like, an oxide film is formed on the surface of the electrodes 3 making an unstable resistance at the time of contact. In order to obtain a stable resistance value of these electrodes 3 by suppressing the variations of the resistance value to not more than 0.5 Ω at the time of contact, the tip of the contact terminal 47 is required to break through the oxide film on the surface of the electrode 3 to secure sufficient contact. For this purpose, it is required to rub each contact terminal against the electrode under a contact pressure of not less than 300 mN per pin, as described in the prior art, in the case where the tip of the contact terminal is semicircular. In the case where the tip of the contact terminal has a flat portion having a diameter in the range of 10 µm to 30 µm, on the other hand, each contact terminal is required to be rubbed against the electrode under the contact pressure of not less than 100 mN per pin. As a result, shavings or scrapings of the electrode material including the oxide film is generated, which is a cause of the short-circuiting between wires and the occurrence of foreign matter. Further, the large contact pressure of 100 mN or more may damage the electrodes or the elements just under them.

In the case where the contact terminal 47 with a sharp tip according to the invention is used, in contrast, a conductive state is obtained with a stable contact resistance of not more than 0.5 Ω simply by pressing without rubbing the contact terminal against the electrode 3 under a contact pressure of about not less than 3 to 50 mN per pin. As a consequence, the electrodes can be contacted under a low pin pressure, so that the electrodes or the elements just under them are prevented from being damaged. Also, the force required for applying the pin pressure to all the contact terminals can be reduced. Therefore, the load resistance of the probe drive unit for a test system using the connecting apparatus can be reduced for a lower production cost.

In the case where it is possible to exert a load of not less than 100 mN per pin, the tip of the contact terminal 47 is not required to be as sharp as a point as far as the contact terminal is a pyramidal protrusion with one side of the bottom thereof about 40 µm long and one side of the tip portion is shorter than 30 µm. For the reason described above, however, the tip is required to be as small and sharp as not more than 5 µm in area.

Also, the use of the contact terminal 47 with a sharp tip makes it unnecessary to rub it against the electrode 3 but only bring it into contact with the electrode 3 under a low pressure of 3 to 50 mN per pin. Thus, the generation of shavings or scrapings of the electrode material is prevented. As a result, the cleaning process which otherwise might be required for removing the shavings of the electrode material after probing is eliminated, thereby leading to a lower production cost.

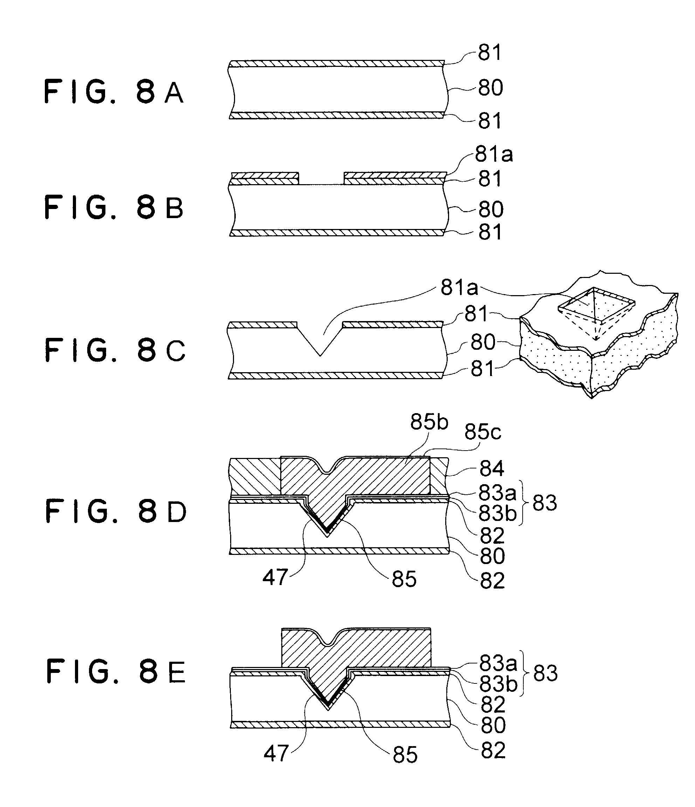

Now, the fabrication process for forming the connecting apparatus (probing apparatus) shown in Fig. 2 will be explained with reference to Figs. 8A to 8E, 9A to 9E and 10A to 10F. Figs. 8A to 8E, 9A to 9E and 10A to 10F show the steps for fabricating the connecting apparatus shown in Fig. 2, in which a pyramidal hole is formed by anisotropic etching in a silicon wafer 80 constituting a cast, and the pyramidal tip of the contact terminal is bonded to the lead wire with a polyimide adhesive sheet having a solder via thereby to form a multilayer film probe sheet which is adjustable through a center pivot 41 with a spring.

First, the step shown in Fig. 8A is executed. In this step, a silicon dioxide film 81 is formed to the size of about 0.5 µm by thermal oxidization on each of the two sides in (100) plane of the silicon wafer 80 having a thickness of 0.2 to 0.6 mm.

Then, the step of etching a silicon dioxide film 81 is executed with a photoresist mask 81a shown in Fig. 8B.

Next, as shown in Fig. 8C, with the silicon dioxide film 81 as a mask, the silicon wafer 80 is anisotropically etched thereby to form a pyramidal etching hole 80a surrounded by the (111) plane. Specifically, using the silicon dioxide film 81 as a mask, the pyramidal etching hole 80a defined by the (111) plane is formed by anisotropic etching.

The next step executed is shown in Fig. 8D. In this step, the (111) plane of the anisotropically etched silicon wafer 80 is formed with a silicon dioxide film 82 to the thickness of about 0.5 µm by thermal oxidization in a wet oxygen, and the resulting surface is formed with a conductive film 83, on which a photoresist 84 is formed. Then, the portion of the photoresist 84 corresponding to the position where the contact terminal 47 is to be formed is removed up to the surface of the conductive film 83, after which the conductive film 83 exposed in the opening of the photoresist 84 is electrically plated with a material containing a hard main component such as nickel with the conductive film 83 as an electrode, thereby integrally forming a bump 85 and a connecting electrode portion 85b as a contact terminal 47.

The bump 85 and the connecting electrode portion 85b formed as an integral unit are then plated with gold 85c. For forming the conductive film mentioned above, a chromium film about 0.1 µm thick is formed by sputtering or evaporation, and a copper film about 1 µm thick is formed on the chromium film by sputtering or evaporation.

Then, the step of removing the photoresist 84 is executed as shown in Fig. 8E.

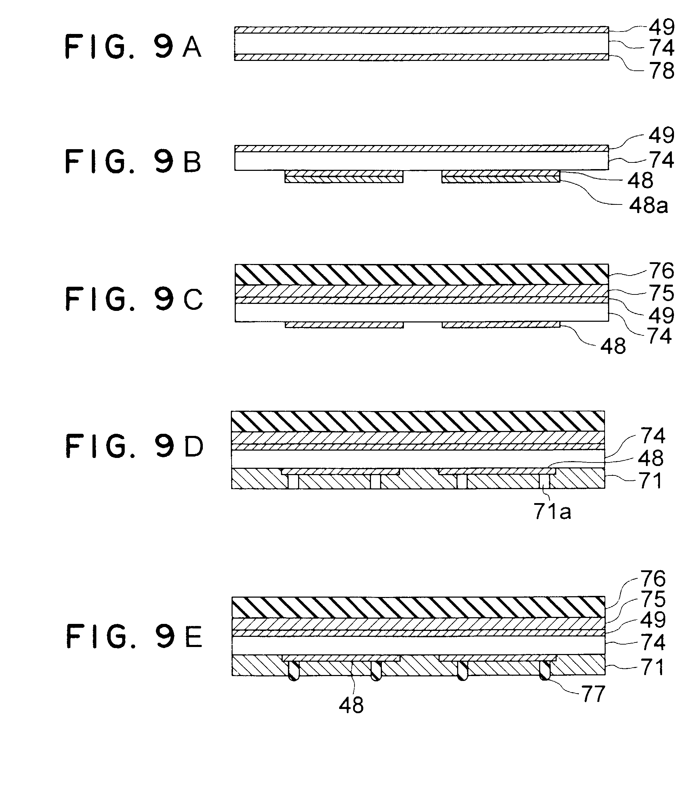

Now, the step shown in Fig. 9A is executed.

First, a base material is prepared which is formed copper layers 49 and 78 on the two sides thereof using a polyimide insulating layer 74, as shown in Fig. 9A.

Then, the step shown in Fig. 9B is executed. In this step, the copper layer 78 is etched with the photoresist mask 48a thereby to form the lead wire 48.

Next, the step shown in Fig. 9C is executed. In this step, a metal layer 76 is attached on the surface of the copper layer 49 described above through an adhesive 75. The adhesive 75 may be a polyimide or epoxy adhesive. The metal layer 76, on the other hand, is a material having a coefficient of linear expansion as low as about 1 to 5 ppm/°C such as invar (an alloy of about 36% nickel and about 64% iron having a coefficient of linear expansion of about 1.5 ppm/°C), for example. This metal layer 76 is attached, by use of the adhesive 75, on the base member through a polyimide insulating layer 74 formed with the copper layer 49 and the lead wire 48 thereby to suppress the difference of the coefficient of linear expansion with the silicon wafer (silicon cast) (with a coefficient of linear expansion of about 2.65 to 2.80 ppm/°C (50°C to 100°C)) 80, thus preventing the cracking and separation of the lead wired 48 and the polyimide films 71, 74 which otherwise might be caused by the temperature stress (about 20°C to 240°C) due to the difference of the coefficient of linear expansion during the subsequent process. In short, the cracking and separation of the lead wire 48 and the polyimide films 71, 74 can be prevented by holding from the two sides with the materials 80, 76 having substantially the same coefficient of linear expansion.

Then, the step shown in Fig. 9D is executed. This step is the one for attaching the adhesive layer 71 on the surface of the insulating layer 74 formed with the lead wires 48 thereby to form the via holes 71a. The via holes 71a may be formed either by use of laser such as an excimer laser or a carbon dioxide gas laser or by wet etching. In another method of forming the adhesive layer 71 having the via holes 71a on the surface of the insulating film 74 formed with the lead wire 48 of the configuration shown in Fig. 9D, the via holes 71a are formed beforehand in the adhesive sheet 71 and attached to the lead wire 48 in position. In both of the above-mentioned cases, the adhesive layer 71 can be composed of polyimide resin.

Then, the step shown in Fig. 9E is executed. This step is to fill a conductive material in the via holes 71a. The conductive material is solder, for example. The solder vias 77 are formed by a method in which the solder paste is screen-printed on the via holes 71a followed by reflow and cleaning flux, or a method in which solder balls are provisionally fixed on the via holes 71a using flux followed by reflow, or a method using solder plating.

In this way, a multilayer wiring film formed with the solder vias 77 can be fabricated.

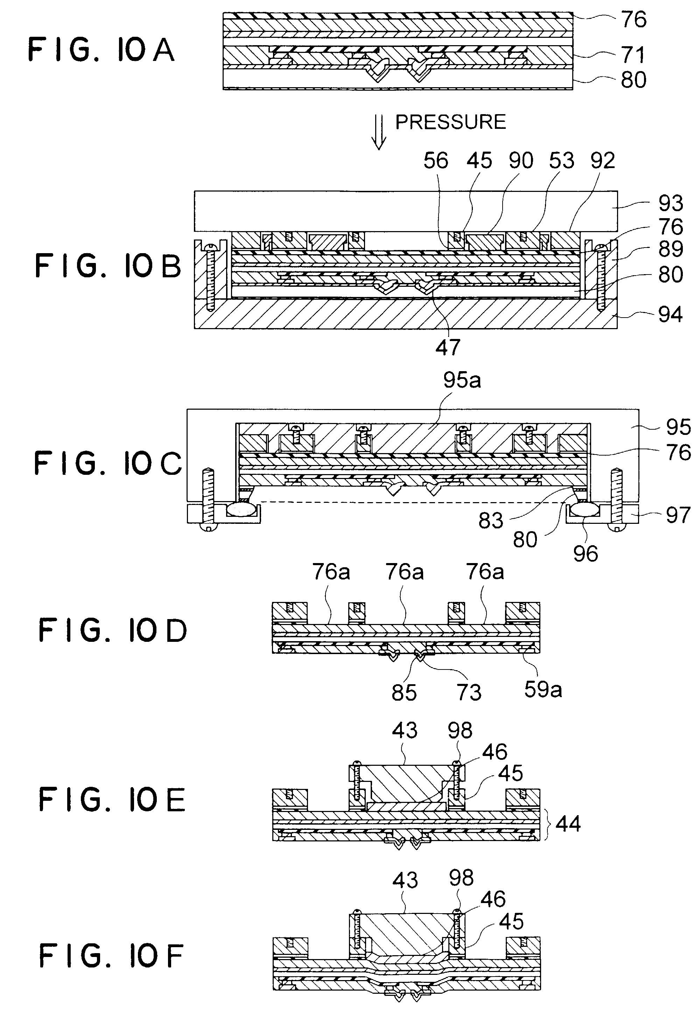

Then, the silicon wafer 80 formed with the contact terminal 47 of Fig. 8E is attached to the multilayer wiring film formed with the solder vias 77 of Fig. 9E, and after thus forming a multilayer wiring film with the contact terminal 47, a connecting apparatus is assembled as shown in the steps shown in Fig. 10.

First, the step shown in Fig. 10A is executed. In this step, the silicon wafer 80 formed with the contact terminal 47 as shown in Fig. 8E is laid over a multilayer film formed with the solder vias 77 and lined with the metal film 76 such as invar as shown in Fig. 9E, followed by the step of bonding by heat under pressure. This bonding by heat under pressure with the assembly held between the silicon wafer 80 formed on the front side and the metal film 76 such as of invar formed on the back as a reference can produce a high-accuracy multilayer wiring film having a cast formed with contact terminals. Specifically, the solder vias of the multilayer wiring film constituting the solder vias 77 of Fig. 9E are set in registry with and overlapped with the contact terminals 47 of the silicon wafer 80 of Fig. 8E, thus bonding them into a multilayer while applying the pressure of 1 to 20 MPa and increasing the temperature thereof to not lower than the glass transition temperature (Tg) of the adhesive layer 71 comprised of the polyimide resin. The relation between the glass transition temperature (Tg) of the adhesive layer 71 and the solder melting point (m.p.) is preferably Tg < m.p. This is by reason of the fact that if the solder melting point is lower than the temperature of the glass transition temperature of the adhesive layer 71, the layers are formed with the solder molten, so that the solder flows out often causing a shorting.

As required, the contact terminal forming multilayer wiring film with a cast, which is integrated by attaching the silicon wafer 80 having the contact terminal 47 and the multilayer wiring film having the vias 77 to each other, may be increased in temperature to the melting point of the solder or higher again under the pressure of 1 to 20 MPa, thereby coupling the contact terminals 47 and the solder vias 77 to each other in metal form.

Then, the step shown in Fig. 10B is executed. In this step, the contact terminal forming multilayer wiring film with a cast, which is formed by integrally attaching the silicon wafer 80 formed with the contact terminals 47 and the multilayer wiring film 44 formed with the solder vias to each other, is placed into a fixing jig 89, and a positioning cast 90 is placed on the surface of the metal film 76 of the contact terminal forming multilayer wiring film with a cast. Then, the frame 45 having the adhesive 56, the peripheral electrode holding member 53 and the peripheral ring 92 are positioned by being fitted in the positioning cast 90. Then, the pressure holding plate 93 and the table 93 are bonded to each other by being heated under pressure. In this way, the frame 45, the peripheral electrode holding member 53 and the peripheral ring 92 are bonded to the surface of the metal film 76 by the adhesive 56. The adhesive 56 may be an epoxy adhesive sheet or a polyimide adhesive sheet. Especially, also in this step, the frame 45 having the adhesive 56, the peripheral electrode holding member 53 and the peripheral ring 92 are placed on the metal film 76 lined on the high-accuracy contact terminal forming multilayer wiring film with a cast, and fixed by being heat under pressure between the pressure holding plate 93 and the table 94. Therefore, even when the silicon wafer is removed subsequently in the step shown in Fig. 10(c), the position of the contact terminal 47 including the flatness of the tip thereof can be set in high accuracy based on the frame 45. Also, the peripheral ring 92 is formed integrally in annular form in order to stabilize the peripheral portion of the multilayer wiring film 44. Thus, the peripheral ring 92 is preferably made of a material having the same coefficient of linear expansion as the frame 45.

Then, the step shown in Fig. 10C is executed. In this step, the silicon wafer 80, which is bonded on the surface of the metal film 76 of the contact terminal forming multilayer film formed with the frame 45, the peripheral electrode holding member 53 and the peripheral ring 92, is mounted with a lid 97 of stainless steel through an O-ring 96 on the fixing jig 95 and the intermediate fixing plate 95a of stainless steel for etching the silicon wafer 80 providing a cast. The silicon wafer 80, the silicon dioxide film 82 and the conductive cover 83 are thus etched off.

In this step, first, the silicon dioxide film 82 is etched off by a mixture solution of hydrofluoric acid and ammonium fluoride, the silicon 80 is etched off with a strong alkali solution (for example, potassium hydroxide), the silicon dioxide film 82 is etched off by a mixture solution of hydrofluoric acid and ammonium fluoride, the chromium film 83b is etched off by the potassium permanganate solution, and the copper film is etched off by the alkali copper etching solution.

In proceeding with the various etching processes described above, first, the silicon dioxide film 82 in the area of the silicon wafer surface to be removed is etched off using the photoresist by a mixture solution of hydrofluoric acid and ammonium fluoride. After that, the silicon wafer 80, which is bonded on the surface of the metal film 76 of the contact terminal forming multilayer film with a silicon cast having the frame 45, the peripheral electrode holder 53 and the peripheral ring 92, is mounted the fixing jig 95 and the intermediate fixing plate 95a of stainless steel in the space with the stainless steel lid 97 through the O-ring 96, and the silicon 80, is etched off by a strong alkali solution (potassium hydroxide, for example). Then, the fixing jig 95 of stainless steel, the intermediate fixing plate 95a and the lid 97 are removed, after which the silicon dioxide film 82 is etched off by a mixture solution of hydrofluoric acid and ammonium fluoride, the chromium film 83b is etched off by a solution of potassium permanganate and the copper film is etched off by an alkali copper etching solution.

Then, the step of Fig. 10D is executed. In this step, the contact terminal forming multilayer wiring film bonded with the frame 45, the peripheral electrode holding member 53 and the peripheral ring 92 is removed from the lid 97, the O-ring 96 and the fixing jig 95. Then, the exposed portion of the metal film 76 (the portion not provided with the frame 45 and the peripheral electrode holding member 53) 76a is etched off, the contact terminal forming multilayer film is cut to an outline as designed, the contact terminal 47 is plated with rhodium 73, and the peripheral electrode 59 is plated with gold 59a. The lined metal film 76 is partially etched off into a pattern for the reason that as shown in Fig. 2, it is necessary to bend this portion when assembling the multilayer film 44. Also, rhodium 73 is plated on the surface of the bump 85 formed of nickel constituting the contact terminal 47 is in view of the fact that the solder and aluminum constituting the material of the electrode 3 is not easily attached, and the rhodium plating is higher in hardness than the material (nickel) of the bump 85, not easily oxidized and has a stable contact resistance. In the case where the iron-nickel alloy is used as the metal film 76, the ferric chloride solution can be used for etching.

Next, the step shown in Fig. 10E is executed. This step is intended to hold the buffer layer 46 between the holding member (holding plate) 43 and the multilayer wiring film 44 and provisionally secure the holding member 43 and the frame 45 to each other with screws 98.

The buffer layer 46 may be made of elastomer, i.e. a sheet of silicon elastomer or a silicon coating material, which is supplied within the frame 45. The buffer layer 46 may not necessarily of the elastomer itself. The function of the buffer layer 46 is to alleviate the whole shock generated when the tip of a multiplicity of the contact terminals 47 come into contact with the electrodes 3 arranged on the semiconductor wafer 1, to absorb by local deformation the variations of not more than about ±2 µm of the height of the tips of the individual contact terminals 47, and thereby to assure contact by uniform bite conforming with the variations of about ±0.5 µm of the height of the contacted members (electrodes) 3 arranged on the semiconductor wafer 1. Especially, according to the embodiment of the invention, the load per pin is so light that the function to alleviate the whole shock is not significant. Once the forward end of the contact terminals 47 can be formed with height variations of not more than about ±0.5 µm, therefore, the buffer layer 46 is not necessarily required. In a method of keeping the height variations of the tips of the contact terminals 47 to not more than about ±0.5 µm, a group of the contact terminals formed on the multilayer film 44 are pressed collectively and uniformly against the silicon substrate having a secured flatness, for example.

The next step executed is shown in Fig. 10F. In this step, the interval between the frame 45 and the holding member (holding plate) 43 is adjusted by screws 98, and the working area 44a of the multilayer film 44 with the contact terminals 47 juxtaposed therein is pressed out by a holding member 43 through the buffer layer 46. In this way, the multilayer wiring film is stretched to an appropriate degree to eliminate the loosening of the multilayer wiring film itself, so that a highly accurate flatness of not more than about ±2 µm is secured for the tips of the multiplicity of the contact terminals.

Then, the assembling step is executed, thereby completing a connecting apparatus (probing apparatus) including a thin film probe card. Specifically, as shown in Fig. 2, the multilayer wiring film 44 is mounted on the wiring board 50. Then, with the lower spherical surface 41a of the center pivot 41 adapted to engage with the taper (tilt) 43c, the taper (tilt) 43c is mounted on the upper surface of the holding member 43. The center pivot 41 is mounted on the support member (upper fixing plate) 40 with the spring probe 42 mounted thereon. At the same time, the wiring board 50 with the multilayer wiring film 44 is mounted on the peripheral portion of the support member 40 thereby to constitute the thin film probe card.

As described above, in the fabrication process shown in Figs. 8A to 8E, the contact terminals 47 are formed on the silicon wafer 80, and in the fabrication process shown in Figs. 9A to 9E, an insulating adhesive sheet (polyimide adhesive sheet, for example) formed with vias (solder vias, for example) 77 of a conductive material is attached on the lead wire 48 of the multilayer wiring film. In the step of Fig. 10A, the lead wire 48 and the insulating adhesive sheet simply laid one on the other are bonded by being heated under pressure, thereby forming a contact terminal forming multilayer film with a cast. In other words, using the insulating adhesive sheet 71 with a cast formed with the vias (solder vias, for example) 77 of a conductive material, the contact terminal 47 with a cast and the lead wire 48 can be connected to each other. Thus, the multilayer film 44 with contact terminals can be fabricated with high yield within a shorter fabrication period.

Now, the fabrication process for forming the connecting apparatus (probing apparatus) shown in Fig. 3 will be explained with reference to Figs. 11A to 11D.

First, the step shown in Fig. 11A is executed. In this step, like the step in Fig. 10A, the silicon wafer 80 formed formed with the contact terminals 47 as shown in Fig. 8E on the one hand and a multilayer wiring film formed with the solder vias as shown in Fig. 9D and lined with a metal film such as of invar on the other hand are laid one on the other and bonded to each other by being heated under pressure. This process of bonding by heat under pressure is conducted while holding the assembly between the silicon wafer 80 formed on the front side and the metal film 76 of invar or the like arranged on the back as a reference. Therefore, it is possible to fabricate a contact terminal forming multilayer film with a cast with high accuracy.

Then, the step shown in Fig. 11B is executed. In this step, the holding member 55 is bonded directly to the metal film 51 with the adhesive 56 in stead of using the frame 45 and the holding member 43 of Fig. 43. The other process is similar to the corresponding process explained with reference to Fig. 10B. Therefore, a structure similar to that shown in Fig. 10B is formed. Also in this step, the holding member 55 having the adhesive 56, the peripheral electrode holding member 53 and the peripheral ring 92 are placed on the metal film 76 lined on the high-accuracy contact terminal forming multilayer film having a cast and bonded while being heated under pressure between the pressure holding member 93 and the table 94. Even in the case where the silicon wafer is removed in the subsequent process of step 11C, therefore, the position of the contact terminals 47 including the flatness of the tip thereof can be set with high accuracy with reference to the holding member 55.

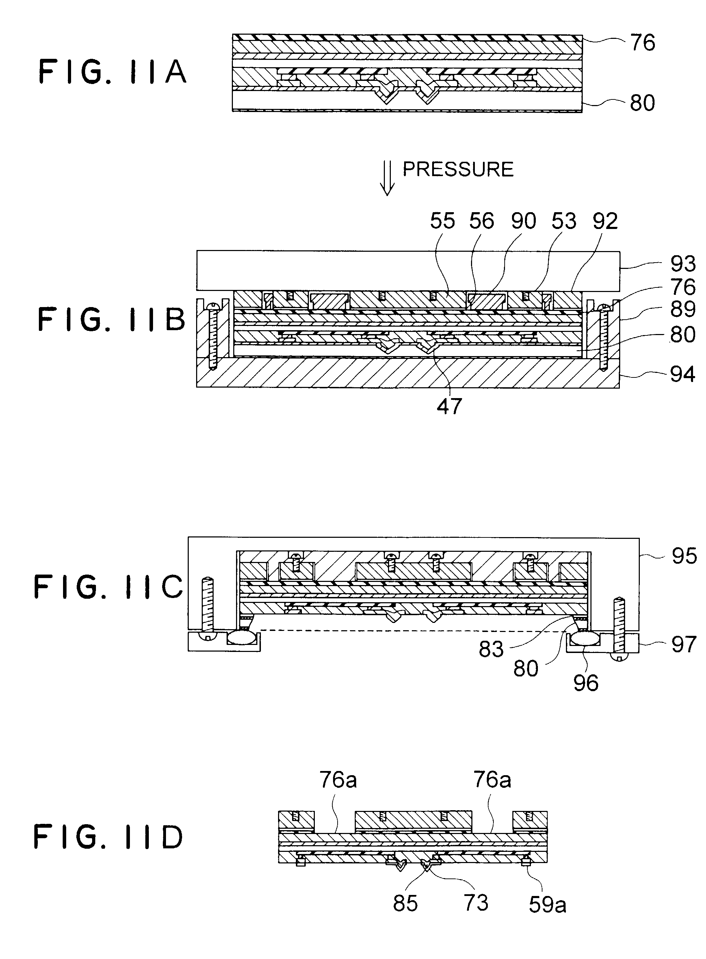

The subsequent processes shown in Figs. 11C and 11D is similar to the process shown in Figs. 10C and Fig. 10D, respectively, and therefore will not be described. Also in this process, the lined metal film 76 is partially etched in view of the need of bending the particular portion when assembling the multilayer wiring film 44 as shown in Fig. 3.

Then, as shown in Fig. 3, the taper 43c is mounted on the upper surface of the holding member 55 with the lower spherical surface 41a of the center pivot 41 in a state adapted to engage the taper (tilt) 43c. The other process is similar to the corresponding one in Fig. 10, through which the connecting apparatus is assembled.

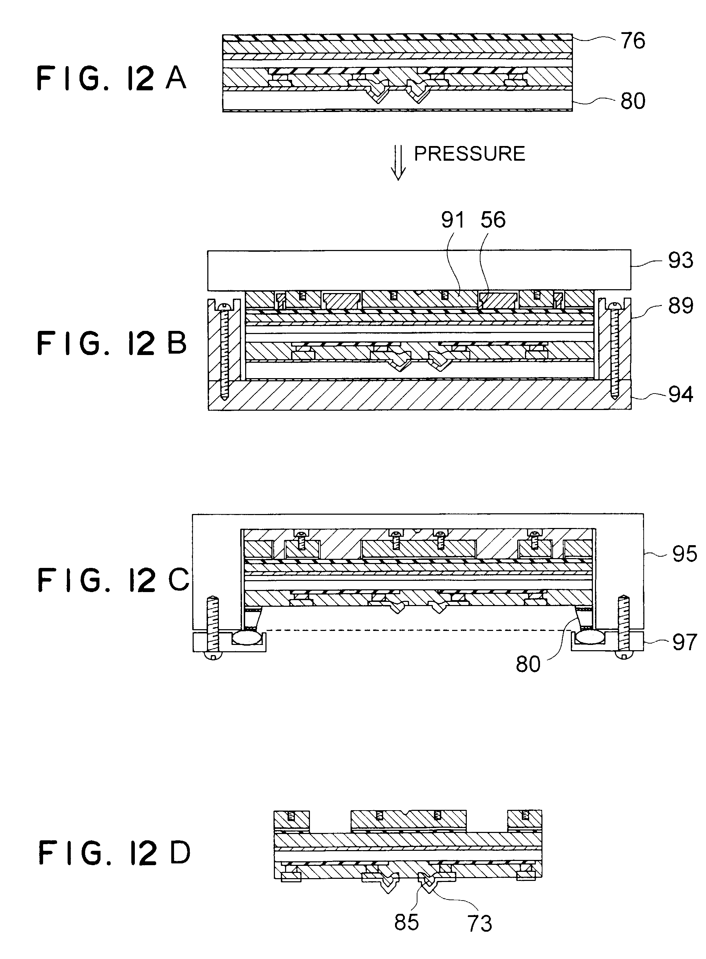

Now, the fabrication process for forming the connecting apparatus (probing apparatus) shown in Fig. 4 will be explained with reference to Figs. 12A to 12D.

First, the step shown in Fig. 12A is executed. In this step which is similar to the step of Fig. 10A, the silicon wafer 80 formed with the contact terminals 47 in Fig. 8E and the multilayer wiring film formed with solder vias of Fig. 9D are laid one on the other and bonded by being heated under pressure.

Then, the step shown in Fig. 12B is executed. In this step, the holding member 91 is directly bonded to the metal film 51 with the adhesive 56, without using the frame 45 and the holding member 43 of Fig. 2. The other process is similar to the corresponding one described with reference to Fig. 10B, and a similar structure to the one shown in Fig. 10B is configured.

The subsequent process shown in Figs. 11C and 11D is similar to the corresponding process shown in Figs. 10C and 10D, respectively, and therefore will not be described.

As shown in Fig. 4, in place of the center pivot 41 included in the configuration of Fig. 2, a center pivot 57 having a spherical tip portion 57a is used so that the pressure against the holding member 91 is applied by a spring 57b, and through the springs 58a of the screws 58 fixed around the holding member 91, the holding member 91 is kept movably in contact with the spherical tip portion 57a. The other processes are similar to the corresponding ones shown in Figs. 10A to 10F by which the connecting apparatus is assembled.

As described above, in the fabrication process shown in Figs. 11A to 11D and Figs. 12A to 12D, like the fabrication process shown in Figs. 10A to 10F, the contact terminals 47 are formed on the silicon wafer 80, and in the fabrication process shown in Fig. 9, the insulating adhesive sheet (such as a polyimide adhesive sheet) 71 formed with vias (solder vias, for example) 77 of a conductive material is formed on the lead wire 48 of the multilayer wiring film. Simply by laying the lead wire 48 and the insulating adhesive sheet one on the other and by bonding them with heat under pressure through the steps of Figs. 11A and 12A, a contact terminal forming multilayer wiring film with a cast can be formed. Specifically, since the contact terminals 47 with a cast and the lead wire 48 can be connected to each other using the insulating adhesive sheet 71 formed with vias (such as solder vias) of a conductive material, it is possible to fabricate the multilayer wiring film 44 with contact terminals with a high yield within a shorter period of time.

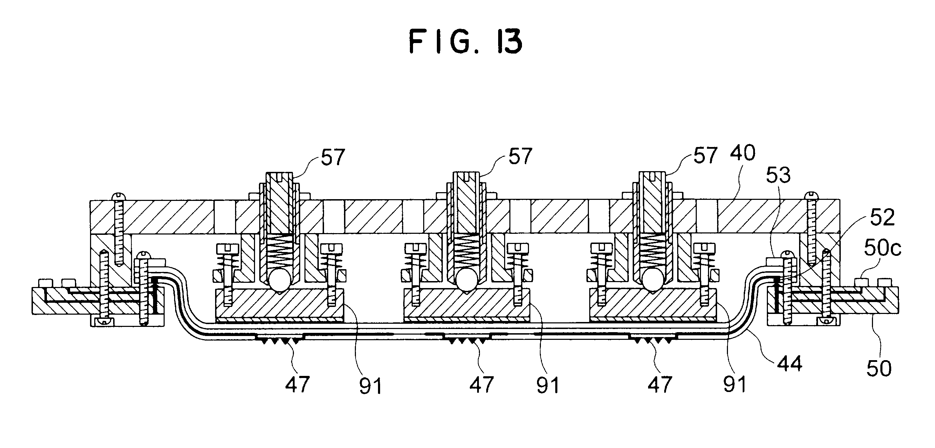

Each of the connecting apparatuses shown in Figs. 2, 3 and 4 is of such a type that the tips of a plurality of probes are set as a group associated with a single holding member (holding plate) 43, 55 or 91, respectively. Nevertheless, as shown in Fig. 13, it is of course also possible to use the type of configuration in which the thin film wiring sheet formed with probe tips is pressed by a plurality of holding members thereby to apply a contact pressure.

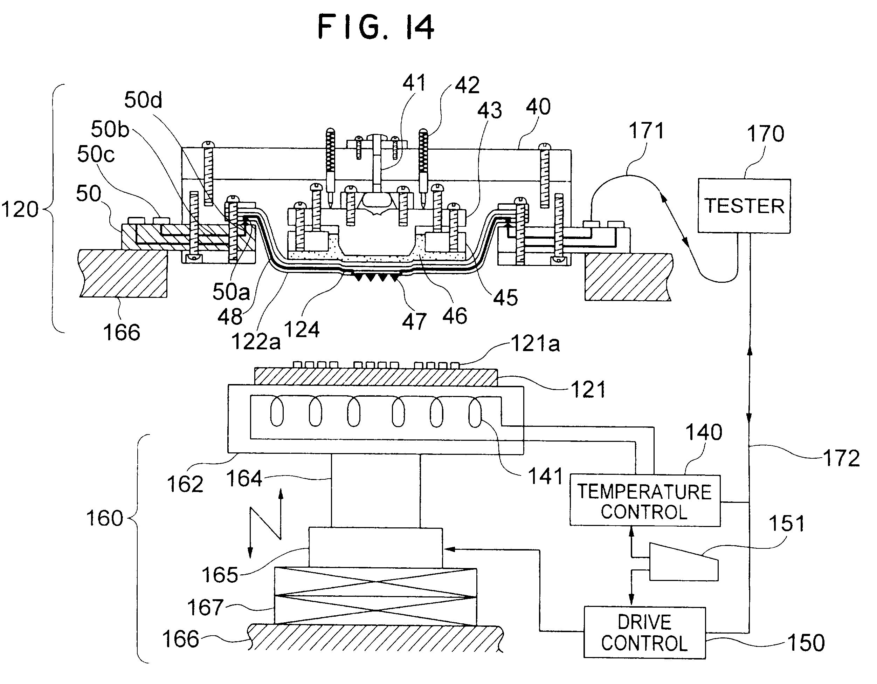

Now, an electrical characteristic test of a semiconductor element (chip) constituting an object to be inspected used for the connecting apparatus (probing apparatus) according to this invention described above will be explained with reference to Fig. 14.

Fig. 14 is a diagram showing a general configuration of an inspection system according to this invention.

The inspection system is configured as a wafer prober for fabrication of a semiconductor device. This inspection system includes a sample support system 160 for supporting a semiconductor wafer 1 providing an object to be inspected, a probe system 120 in contact with the electrodes 3 of the object to be inspected for transmitting and receiving the electrical signals, a drive control system 150 for controlling the operation of the sample support system 160, a temperature control system 140 for controlling the temperature of the object to be inspected 1, and a tester 170 for checking the electrical characteristics of the semiconductor elements (chips) 2. The semiconductor wafer 1 has a multiplicity of semiconductor elements (chips) 2 arranged therein. With the increase in the integration of the semiconductor elements proceeds, a plurality of electrodes 3 constituting electrodes for connection with external devices have come to be arranged with higher density and with narrower pitch. The sample support system 160 includes a sample table 162 arranged substantially horizontally with the semiconductor wafer 1 placed thereon removably, a lift shaft 164 arranged in a vertical position in such a manner as to support the sample table 162, a lift drive unit 165 for driving the vertical motion of the lift shaft 164, and an X-Y stage 157 for supporting the lift drive unit 165. The X-Y stage 167 is fixed on a housing 166. The lift drive unit 165 is configured, for example, of a stepping motor. The positioning operation in horizontal and vertical directions of the sample table 162 is performed by the moving operation of the X-Y stage within the horizontal plane and the vertical operation of the lift drive unit 165 combined.

The sample table 162 has a rotational mechanism not shown whereby the rotational displacement of the sample table 162 is made possible in a horizontal plane.

The probe system 120 is arranged above the sample table 162. Specifically, the connecting apparatus 120a and the insulating board 50 shown in Figs. 2, 3 or 4 are arranged in parallel opposed relation to each other on the sample table 162. In the case of the connecting apparatus 120a shown in Fig. 2, for example, the multilayer wiring film 44 having contact terminals 47, the buffer layer 46, the frame 45, the holding member (holding plate) 43, the center pivot 41, the spring probes 42 and the support member (upper fixing plate) 40 are arranged integrally. Each contact terminal 47 is connected to a connecting terminal 50c arranged on the wiring board 50 through the lead wire 48 arranged on the multilayer wiring film 44 of the connecting apparatus 120a, the electrode 50a and the vias 50d of the wiring board 50 and the internal wire 50b. According to this embodiment, the connecting terminal 50c is configured with a coaxial connector, and connected to the tester 170 through a cable 171 connected to the connecting terminal 50c.

The connecting apparatus involved has a structure shown in Fig. 2 but not limited thereto, and can of course have the structure shown in Fig. 3 or 4.

The drive control system 150 is connected to the tester 170 through the cable 172. The drive control system 150 also sends a control signal to the actuator of each drive unit of the sample support system 160 and controls the operation thereof. Specifically, the drive control system 150 includes a computer therein for controlling the operation of the sample support system 160 in accordance with the information on the progress of the test operation of the tester 170 transmitted through the cable 172. Also, the drive control system 150 includes an operating unit 151 for receiving various instructions for the drive control such as a designation for manual operation.

The sample table 162 includes a heater 141 for generating heat for conducting a burn-in test on the semiconductor element 2. The temperature control system 140 controls the temperature of the semiconductor wafer 1 mounted on the sample table 162 by controlling the heater 141 or the cooling jig of the sample table 162. Also, the temperature control system 140 includes the operating unit 151 for receiving various instructions input thereto for temperature control, such as the designation of manual operation.

The operation of the inspection system will be explained below. First, the semiconductor wafer 1 constituting an object to be inspected is mounted in position on the sample table 162. Then, an optical image of plurality of reference marks formed in spaced relation on the semiconductor wafer 1 mounted on the sample table 162 are picked up by an imaging device (not shown) such as an image sensor or a TV camera, so that the positions of a plurality of the reference marks are detected from the image signals obtained. With reference to the positional information of a plurality of the detected reference marks on the semiconductor wafer 1, the drive control system 150 calculates the two-dimensional position information for the whole group of the electrodes based on the information on the arrangement of the semiconductor elements 2 on the semiconductor wafer 1 and the information on the arrangement of the electrodes 3 on each semiconductor element 2 obtained from the CAD data in accordance with the type of the semiconductor wafer 1 stored in the tester 170 or the drive control system 150. Further, an optical image of the tip of specific one of a multiplicity of the contact terminals 47 formed on the multilayer wiring film 44 or an optical image of a plurality of reference marks formed in spaced relation on the multilayer wiring film 44 are picked up by an imaging device (not shown) such as an image sensor or a TV camera, so that the position of the specific contact terminal or a plurality of the reference marks obtained by this image pickup operation is detected. Based on the probe information including the arrangement and height of the contact terminals corresponding to the type of the probe input and stored by the operating unit 151, the drive control system 150 calculates the two-dimensional position information of the whole group of the contact terminals from the position information of a specific contact terminal or a plurality of reference marks on the multilayer wiring film 44 detected as above. The drive control system 150 calculates the displacement of the two-dimensional position information for the whole group of the electrodes with respect to the two-dimensional position information for the whole group of the contact terminals calculated, and based on the two-dimensional displacement thus calculated, controls the drive of the X-Y stage 167 and the rotational mechanism, so that the groups of the electrodes 3 formed on a plurality of the semiconductor elements arranged on the semiconductor wafer 1 are set in position just under the group of a multiplicity of the contact terminals juxtaposed on the connecting apparatus 120a. After that, the drive control system 150, based on the gap with the surface of the working area 44a of the multilayer wiring film 44 measured by a gap sensor (not shown) installed on the sample table 162, for example, activates the lift drive unit 165, and moves up the sample table 162 by about 8 to 20 µm until the whole surface 3a of the multiplicity of the electrodes (contacted members) 3 comes into contact with the tips of the contact terminals. In this way, the working area 44a of the multilayer wiring film 44 where a multiplicity of the contact terminals 47 are arrayed is extended so that the tips, with the flatness thereof secured with high accuracy, of the group of a multiplicity of the contact terminals 47 are set in parallel by a compliance mechanism following the surface 3a of the (whole) group of a multiplicity of the electrodes 3 arranged over each of a plurality of the intended semiconductor elements. At the same time, the variations of not more than about ±2 µm of the tip height of the contact terminals are absorbed by the local deformation of the buffer layer 46, with the result that the contact by bite is attained based on a uniform light load (about 3 to 50 mN per pin) following the contacted members (electrodes) 3 arranged on the semiconductor wafer 1, thereby connecting each contact terminal 47 and each electrode 3 with a low resistance (0.01 Ω to 0.1 Ω).

The drive control of the stage 167, the rotational mechanism and the lift drive unit 165 by the drive control unit 150 is carried out in response to the operating instructions from the operating unit 151. Especially, the sample table 162 is moved upward by the lift drive unit 165 by about 8 to 100 µm from the time point when the whole surface 3a of the electrode (contacted member) 3 reaches the corresponding tip of the contact terminal, so that the whole of a multiplicity of the contact terminals 47 are set in parallel in accordance with the whole surface 3a of a multiplicity of the electrodes (contacted members) 3. At the same time, the height variations of the tips of the contact terminals are absorbed by the buffer layer 46 thereby assuring the contact by bite based on a uniform light load (about 3 to 50 mN per pin), with the result that each contact terminal 47 and a corresponding electrode 3 are connected to each other with a low resistance of 0.01 Ω to 0.1 Ω.

Under this condition, a burn-in test can be conducted on the semiconductor elements 2 by controlling the heater 141 or the cooling jig of the sample table 162 by the temperature control system 140 and thus by controlling the temperature of the semiconductor wafer 1 mounted on the sample table 162.

Further, the operating power and the operating test signals are transmitted and received between the semiconductor elements formed on the semiconductor wafer 1 and the tester 170 through the cable 171, the wiring board 50, the multilayer film 44 and the contact terminals 47 thereby to determine the legitimacy of the operation characteristics of the semiconductor elements. In the process, as shown in Fig. 4, the multilayer wiring film 44 is formed with a ground layer 49 in opposed relation to the lead wire 48, with the insulating film 66 (74) in-between, connected to each contact terminal 47, and the impedance Z0 of the lead wire 48 is set to about 50 ohm to secure the matching with the tester circuit. Thus, the disturbance and attenuation of the electrical signals transmitted through the lead wire 48 are prevented, thereby making it possible to realize an electrical characteristic inspection of the semiconductor elements by the tester with a high-speed electrical signal that can meet the radio frequency of up to about 100 MHz to several tens of GHz.

The series of the test operation described above are conducted on each of a plurality of semiconductor elements formed on the semiconductor wafer 1 to determine the legitimacy of the operation characteristics thereof.

This invention has the effect of making possible the probing of a narrow-pitch multi-pin structure of high-density semiconductor elements in stable fashion with light load without damaging the object to be inspected while at the same time making it possible to transmit high-speed electrical signals, i.e. high frequency electrical signals of about 100 MHz to several tens of GHz.

Also, according to the invention, the provision of the compliance mechanism for eliminating the loosening of and setting in parallel the working area of a multilayer wiring film with contact terminals having a sharp tip arrayed therein, so that shavings or scrapings of the electrode material and the like is prevented from being generated simply by pressing, with a load as light as about 3 to 50 mN per pin, the group of the contact terminals having a sharp tip against the electrode group on the object to be inspected, thereby exhibiting the effect of realizing stable connection with a low resistance of about 0.05 Ω to 0.1 Ω.

Further, according to this invention, one or a multiplicity of semiconductor elements (chips) among those arrayed in a wafer can be securely connected at the same time to the electrodes 3 of aluminum or solder having the surface thereof formed with an oxide, with a stable low resistance value of about 0.05 Ω to 0.1 Ω and a small contact pressure of about 3 to 50 mN per pin, thereby exhibiting the effect of making it possible to conduct an operation test on each semiconductor element with a tester. Specifically, according to this invention, the current requirement for a higher density and a narrower pitch of the electrodes can be met, and a multiplicity of chips can be inspected by probing at the same time. Also, an operation test is made possible with a high-speed electrical signal of about 100 MHz to several tens of GHz in frequency.

Furthermore, according to this invention, a high-temperature operation test such a burn-in test is made possible by use of a material which can resist high temperatures such as polyimide as a material of the insulating film for the multilayer wiring film.

Also, according to this invention, even in the case where the temperature changes (-10°C to 150°C) at the time of inspection, the position of the contact terminals formed on the wiring film as relative to the position of the electrodes of the object to be inspected (semiconductor element, for example) is stabilized, thereby exhibiting the effect of realizing a reliable connecting apparatus having a superior contact characteristic as well as high position accuracy.

Further, according to this invention, the wiring film with a holder constituting the connecting apparatus can be fabricated inexpensively with a high yield within a short period of time.

## Claims

1. A connecting apparatus for transmitting and receiving electrical signals by electrical contact with the electrodes (3) arranged on an object to be inspected (1), comprising:
a support member (40) for supporting said connecting apparatus;
a multilayer film (44) including a plurality of contact terminals (47) arrayed on the probing side of a working area (44a), a plurality of lead wires (48) electrically connected to each of said contact terminals through a conductive material in an insulating film and led out to the peripheral portion of said multilayer film, and a metal film (51) formed by being partially lined at positions corresponding to said working area on said plurality of said lead wires with an insulating layer therebetween;
a holding member (55) for mounting at least the metal layer portion of the multilayer film in such a manner as to eliminate the loosening of said working area of said multilayer film; and
means (42) for applying a contact pressure from said support member to said holding member for bringing each of said contact terminals into contact with the corresponding one of said electrodes.

2. A connecting apparatus for transmitting and receiving electrical signals by electrical contact with the electrodes arranged on an object to be inspected, comprising:
a support member for supporting said connecting apparatus;
a multilayer film including a plurality of contact terminals disposed on the probing side of a working area, a plurality of lead wires electrically connected to each of said contact terminals through a conductive material in an insulating film and led out to the peripheral portion of said multilayer film, a ground layer (49) formed in opposed relation to said lead wires with an insulating layer therebetween, and a metal film formed on said ground layer by being partially lined at positions corresponding to said working area with said insulating layer therebetween;
a holding member for mounting at least the metal layer portion of the multilayer film in such a manner as to eliminate the loosening of said working area of said multilayer film; and
means for applying a contact pressure from said support member to said holding member for bringing each of said contact terminals into contact with each of said electrodes.

3. A connecting apparatus according to Claim 1 or 2, further comprising a compliance mechanism for causing said holding member to engage said support member in such a manner that a surface defined by said contact terminals is set in parallel according to a surface defined by the electrode group when said surface of said contact terminal group is brought into contact with the surface of said electrode group.

4. A connecting apparatus according to Claim 1, 2 or 3, further comprising a buffer layer interposed between the back of the working area of said multilayer film and said holding member.

5. A connecting apparatus according to Claim 1, 2, 3 or 4,
wherein said conductive material of said multilayer film is filled in said insulating film.

6. A connecting apparatus according to Claim 1, 2, 3 or 4,
wherein said conductive material of said multilayer film is solder vias filled in said insulating film.

7. A connecting apparatus according to Claim 1, 2, 3 or 4,
wherein said conductive material of said multilayer film in said insulating film is solder vias embedded in a polyimide film.

8. A connecting apparatus according to Claim 1, 2, 3 or 4,
wherein said metal film is made of a metal material having a coefficient of linear expansion of 1 to 5 ppm/°C.

9. A method of fabricating a wiring film with a holding member constituting a connecting apparatus for transmitting and receiving electrical signals by electrical contact with the electrodes arranged on an object to be inspected, comprising the steps of:
forming an etching hole with a sharp tip at a plurality of points on the cast, and forming a plurality of contact terminal electrodes of a conductive material each having a protrusion for the contact terminal in an area including said etching holes, thereby producing a plurality of contact terminals with a cast;
forming at least a lead wire on an insulating film, forming a plurality of via holes in an adhesive layer connected to an end of said lead wires, attaching said adhesive layer on said lead wires, forming a plurality of via holes each connected to an end of each of said lead wires on said insulating layer, and filling a conductive material in said via holes, thereby producing a wiring film;
laying each contact terminal with a cast obtained in said contact terminal forming step and the wiring film obtained in said wiring film forming step, one on the other, heating said assembly under pressure thereby to embed the base of said contact terminal electrode in said adhesive layer and connect said contact terminals with said vias, and bonding said contact terminals with a cast and said wiring film with said adhesive layer, thereby producing a wiring film with a cast;
mounting a holding member on that surface of said wiring film with a cast obtained in said mounting step which is on the opposite side of said contact terminals; and
removing said cast from said wiring film obtained in said mounting step, connecting said wiring film with said vias, and embedding the base of said wiring film in said adhesive layer, thereby producing a wiring film having a protruded contact terminal.

10. A method of fabricating a wiring film with a holding member constituting a connecting apparatus for transmitting and receiving electrical signals by electrical contact with the electrodes arranged on an object to be inspected, comprising the steps of:
forming an etching hole with a sharp tip at a plurality of points on a cast, and forming at least a contact terminal electrode of a conductive material having a protrusion for the contact terminal in an area including said etching holes, thereby producing a plurality of contact terminals with a cast;
forming at least a lead wire on an insulating film, attaching an adhesive layer on said lead wire, forming a plurality of via holes in the adhesive layer connected to an end of said lead wires, and filling a conductive material in said via holes, thereby producing a wiring film;
laying each contact terminal with a cast obtained in said contact terminal forming step and the wiring film obtained in said wiring film forming step, one on the other, heating said assembly under pressure thereby to embed the base of said contact terminal electrode in said adhesive layer and connect said contact terminal with said vias, and bonding said contact terminal with a cast and said wiring film with said adhesive layer, thereby producing a wiring film with a cast;
mounting a holding member on that surface of said wiring film with a cast obtained in said mounting step which is on the opposite side of said contact terminal; and
removing said cast from said wiring film obtained in said mounting step, connecting said wiring film with said vias, and embedding the base of said wiring film in said adhesive layer, thereby producing a wiring film having a protruded contact terminal.

11. A method of fabricating a wiring film with a holding member constituting a connecting apparatus for transmitting and receiving electrical signals by electrical contact with the electrodes arranged on an object to be inspected, comprising the steps of:
forming an etching hole with a sharp tip at a plurality of points on a cast, and forming a contact terminal electrode of a conductive material having a protrusion for the contact terminal in an area including said etching holes, thereby producing a plurality of contact terminals with a cast;
forming a lead wire on an insulating film, forming a plurality of via holes on said lead wire at positions connected to an end of said lead wire, attaching an adhesive sheet filled with a conductive material on said via holes, thereby producing a wiring film;
laying each contact terminal with a cast obtained in said contact terminal forming step and the wiring film obtained in said wiring film forming step, one on the other, heating said assembly under pressure thereby to embed the base of said contact terminal electrode in said adhesive sheet and connect said contact terminal with said vias, and bonding said contact terminal with a cast and said wiring film to each other with said adhesive sheet, thereby producing a wiring film with a cast;
mounting a holding member on that surface of said wiring film with a cast obtained in said mounting step which is on the opposite side of said contact terminals; and
removing said cast from said wiring film with a cast obtained in said mounting step, connecting said wiring film with said vias, and embedding the base of said wiring film in said adhesive sheet, thereby producing a wiring film having a protruded contact terminal.

12. A method of fabricating a wiring film with a holding member according to claim 9, 10 or 11,
wherein said step of forming a wiring film further includes the substep of bonding a metal film by lining on the back or above the back of the insulating film of said wiring film using an adhesive.

13. A method of fabricating a wiring film with a holding member according to claim 9, 10 or 11,
wherein said step of forming a wiring film further includes the substep of bonding a metal film having a coefficient of linear expansion of 1 to 5 ppm/°C by lining on the back or above the back of the insulating film of said wiring film using an adhesive.

14. A method of fabricating a wiring film with a holding member according to claim 9 or 10,
wherein said adhesive layer used in said step of forming a wiring film is made of polyimide.

15. A method of fabricating a wiring film with a holding member according to claim 11,
wherein said adhesive sheet used in said step of forming a wiring film is made of polyimide.

16. A method of fabricating a wiring film with a holding member according to claim 9, 10 or 11,
wherein said vias formed in said step of forming a wiring film are solder vias.

17. A method of fabricating a wiring film with a holding member according to claim 9, 10 or 11,
wherein said step of forming the wiring film further includes the substep of forming a ground layer on the back of the insulating layer of said wiring film.

18. A method of fabricating a wiring film with a holding member according to claim 9, 10 or 11,
wherein said step of forming the wiring film further includes the substeps of forming a ground layer on the back of the insulating layer of said wiring film and bonding a metal film, using an adhesive, on the back of the ground layer formed in said ground layer forming step.

19. A method of fabricating a wiring film with a holding member according to claim 9, 10 or 11,
wherein said step of forming the wiring film further includes the substeps of forming a ground layer on the back of the insulating layer of said wiring film and bonding a metal film having a coefficient of linear expansion of 1 to 5 ppm/°C, using an adhesive, on the back of the ground layer formed in said ground layer forming step.

20. A method of fabricating a wiring film with a holding member according to claim 12, 13, 18 or 19,
wherein said mounting step includes the substep of removing the desired portion exposed by said metal film in such a manner that the wiring film with a holder can be bent when mounting said holding member.

21. An inspection system comprising:
a sample support system for mounting and supporting an object to be inspected thereon,
a connecting apparatus including a support member; a multilayer film including a plurality of contact terminals arrayed on the probing side of a working area, a plurality of lead wires electrically connected to each of said contact terminals through a conductive material in an insulating film and led out to the peripheral portion of said multilayer film, a ground layer formed in opposed relation to said lead wires with an insulating layer therebetween, and a metal film formed by being partially lined at positions corresponding to said working area on said ground layer with said insulating layer therebetween; a holding member for mounting at least the metal layer portion of the multilayer film in such a manner as to eliminate the loosening of said working area of said multilayer film; and means for applying a contact pressure from said support member to said holding member for bringing each of said contact terminals into contact with each of said electrodes,
a tester electrically connected to the lead wire led out to the peripheral portion of the multilayer film of said connecting apparatus,
means for positioning the group of the contact terminals arrayed on the multilayer film of said connecting apparatus and the group of the electrodes arranged on the object to be inspected, and
means for bringing the contact terminal group positioned by said positioning means and the electrode group arranged on said object to be inspected into contact with each other, so that an electrical signal is transmitted and received between said object to be inspected and said tester thereby to inspect said object to be inspected.

22. A method of fabricating at least a semiconductor element by bringing the contact terminal group into contact with the electrode group arranged in each semiconductor element, transmitting and receiving electrical signals to and from the semiconductor element from a tester and thus inspecting the electrical characteristics of said semiconductor element, using an inspection system comprising:
a sample support system for mounting and supporting a semiconductor element thereon,
a connecting apparatus including a support member; a multilayer film including a plurality of contact terminals arrayed on the probing side of a working area, a plurality of lead wires electrically connected to each of said contact terminals through a conductive material in an insulating film and led out to the peripheral portion of said multilayer film, a ground layer formed in opposed relation to said lead wires with an insulating layer therebetween, and a metal film formed by being partially lined at positions corresponding to said working area on said ground layer with said insulating layer therebetween; a holding member for mounting at least the metal layer portion of the multilayer film in such a manner as to eliminate the loosening of said working area of said multilayer film; and means for applying a contact pressure from said support member to said holding member for bringing each of said contact terminals into contact with each of said electrodes,
a tester electrically connected to the lead wire led out to the peripheral portion of the multilayer film of said connecting apparatus, and
means for positioning the group of the contact terminals arrayed on the multilayer film of said connecting apparatus and the group of the electrodes arranged on the semiconductor element.
